# EUROPÄISCHE PATENTANMELDUNG

(11) **EP 1 300 880 A2**
(43) Veröffentlichungstag der Anmeldung: **09.04.2003**
(21) Anmeldenummer: 02019495.7
(22) Anmeldetag: 30.08.2002
(51) Int. Cl.: H01L 21/336, H01L 29/78, H01L 21/027

(54) **Verfahren zum photolithographischen Festlegen eines freigelegten Substratbereichs**

(30) Priorität: 05.10.2001 DE 10149028
(71) Anmelder: Infineon Technologies AG, 81669 München (DE)
(72) Erfinder: Taddiken, Hans, 81737 München (DE)
(74) Vertreter: Schoppe, Fritz, Dipl.-Ing.

(57) **Zusammenfassung**

Bei einem Verfahren zum photolithographischen Festlegen eines freigelegten Substratbereichs, der direkt an eine auf dem Substrat (200, 202) angeordnete Struktur (206) angrenzt, wird zunächst eine Maskierungsschicht (216) auf dem Substrat (200, 202) aufgebracht, die bis an die Struktur (206) heranreicht. Anschließend wird eine Photoresistschicht (222) aufgebracht, und eine Kante (224) der Photoresistschicht (222) wird in einer Solllage photolithographisch festgelegt. Die Solllage ist mindestens um eine Justagetoleranz eines Belichtungsverfahrens von einer Kante der Struktur (206) beabstandet, die an einen nicht zu entfernenden Abschnitt der Maskierungsschicht (216) angrenzt, um eine Istlage der Kante (224) der Photoresistschicht (222) zu erhalten, die entweder oberhalb der Struktur (206) oder oberhalb des zu entfernenden Abschnitts der Maskierungsschicht (216) liegt. Abschließend wird die Maskierungsschicht (216) unter Verwendung der strukturierten Photoresistschicht (222) geätzt, um die Maskierungsschicht (216) bis zu der Struktur (206) zu entfernen.

## Beschreibung

Die vorliegende Erfindung bezieht sich auf ein Verfahren zur photolithographischen Festlegung eines freigelegten Substratbereichs, der direkt an eine auf dem Substrat angeordnete Struktur angrenzt. Die vorliegende Erfindung bezieht sich insbesondere auf ein Verfahren zum Freilegen eines Substratbereichs, auf dem ein Gate eines MOS-Transistors angeordnet ist, wobei zwischen einer Sourceimplantation und einer Drainimplantation ein leicht dotierter Drainbereich zu implantieren ist. Insbesondere bezieht sich die vorliegende Erfindung auf die Herstellung von LDMOS-Transistoren (LDMOS = Lateral Diffused MOS = lateral diffundierter MOS).

Bei der Herstellung von Halbleiterstrukturen werden Situationen angetroffen, in denen auf einem Substrat bereits eine oder mehrere Strukturen angeordnet sind, und in denen es erwünscht ist, auf unterschiedlichen Seiten der bereits existierenden Strukturen unterschiedliche Prozessschritte für eine Weiterprozessierung der Halbleiterstruktur durchzuführen. In einer solchen Situation ist sicherzustellen, dass die zwei Bereiche während der Prozessierung des jeweils anderen Bereiches sicher voneinander getrennt sind.

Ein Beispiel für solche Situationen ist die Herstellung von leicht dotierten Drainbereichen, sogenannten LDD-Bereichen (LDD = Lightly Doped Drain), von MOS-Transistoren (MOS = Metal Oxid Semiconductor = Metall-Oxid-Halbleiter) oder von LDMOS-Transistoren. Bei MOS-Transistoren für Hochleistungsanwendungen und bei LDMOS-Transistoren für Hochfrequenz-Leistungsanwendungen ist es erforderlich, auf der einen Seite des Gates die Sourceimplantation durchzuführen, und auf der anderen Seite des Gates den LDD-Bereich, z. B. durch eine n-Implantation, zu erzeugen. Bei LDMOS-Transistoren wird zusätzlich, vor der Sourceimplantation, auf der Sourceseite des Gates die erforderliche Kanalimplantation eingebracht, die dann mit einem nachfolgenden Temperaturschritt zu einem späteren Zeitpunkt während der Herstellung unter das Gate diffundiert wird. Die Trennung zwischen dem an das Gate angrenzenden Sourcebereich und dem an das Gate angrenzenden LDD-Bereich ist für die zuverlässige Herstellung der Bauelemente von großer Bedeutung.

Im Stand der Technik wird diese Trennung bisher unter Verwendung einer Phototechnik durchgeführt, bei der jeweils eine Seite, entweder der Sourcebereich oder der LDD-Bereich benachbart zu dem Gate mit einem Photolack abgedeckt wird, und eine Lackkante auf dem Gate erzeugt wird.

Der Nachteil bei dieser Vorgehensweise besteht darin, dass hier die Justage-Toleranzen der verwendeten Lithographie-Geräte berücksichtigt werden müssen. Diese erforderliche Berücksichtigung der Justage-Toleranzen begrenzt die mögliche minimale Gatelänge da die Justage-Toleranzen größer sind als die durch die Lithographie erreichbare minimale Strukturbreite.

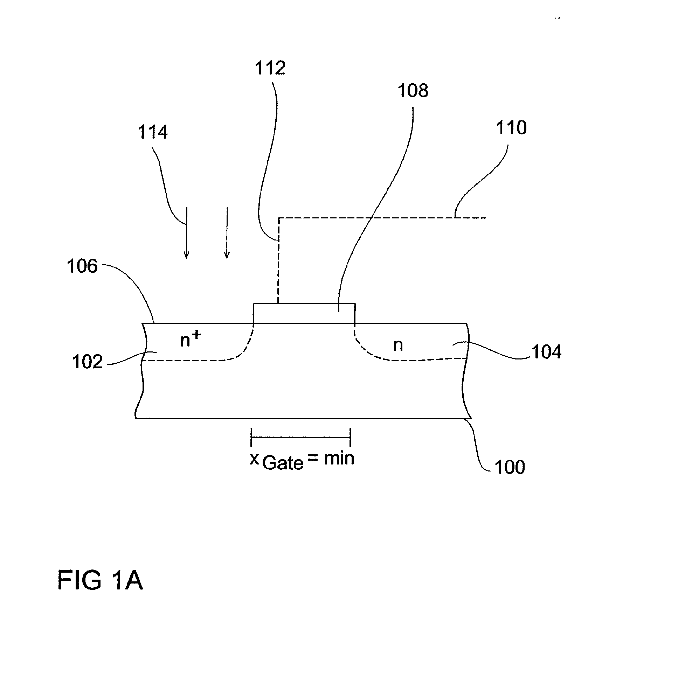

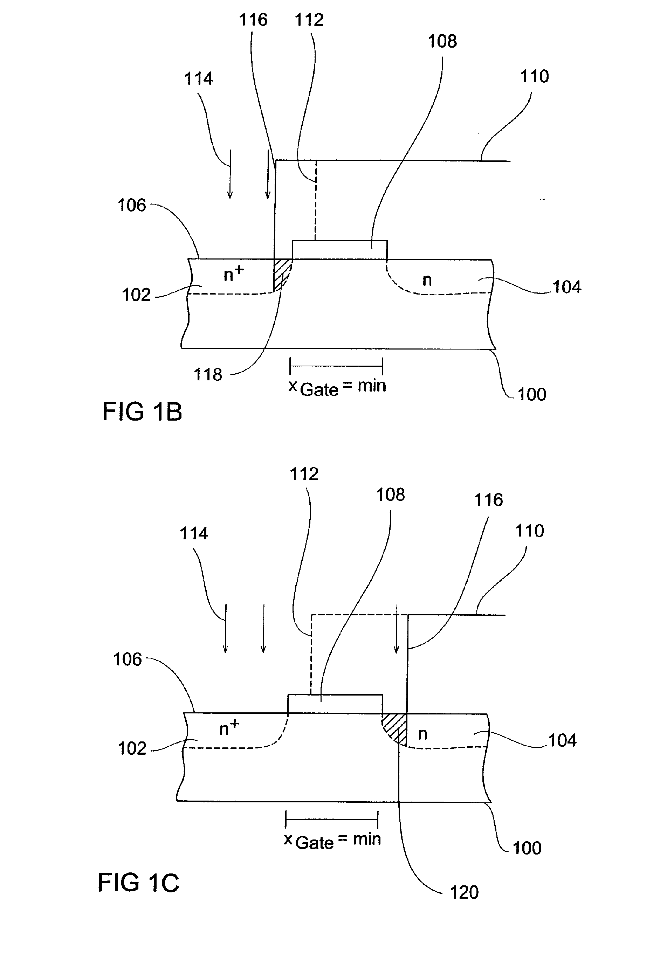

Diese Problematik wird nachfolgend anhand der Fig. 1A bis 1C erläutert. In Fig. 1 ist beispielhaft ein Substrat 100 gezeigt, in dem eine MOS-Transistorstruktur mit einem LDD-Bereich erzeugt werden soll. Schematisch ist im Substrat 100 ein Sourcebereich 102 gezeigt, in dem während der Herstellung die Source des MOS-Transistors zu erzeugen ist. Ebenso ist schematisch ein LDD-Bereich 104 gezeigt, der in nachfolgenden Prozessschritten zu erzeugen ist. Ferner ist auf einer Oberfläche 106 des Substrats 100 eine Gatestruktur 108 angeordnet benachbart zu der der Sourcebereich 102 bzw. der LDD-Bereich 104 zu erzeugen ist. Die Gatestruktur 108 hat eine minimale Abmessung x_{Gate}, welche durch die durch die Lithographie erreichbare minimale Strukturbreite gegeben ist. Die mit heutigen Lithographie-Verfahren in der Produktion eingesetzten minimalen Strukturgrößen liegen etwa im Bereich von 0,2 um.

Um die Trennung zwischen dem Sourcebereich 102 und dem LDD-Bereich 104 sicherzustellen, wird mittels Phototechnik eine Lackmaske erzeugt, deren Idealanordnung in Fig. 1A bei 110 gezeigt ist. Die Lackmaske 110 hat eine Kante 112, die auf der Gatestruktur 108 angeordnet ist, so dass der LDD-Bereich vollständig von der Maske 110 bedeckt ist, so dass während einer nachfolgenden Bearbeitung des Sourcebereichs 102, wie beispielsweise einer Implantation (siehe die Pfeile 114) eine gleichzeitige Bearbeitung des LDD-Bereichs sicher vermieden wird.

Die Problematik im Zusammenhang mit der Photomaske 110 besteht jedoch darin, dass die Justage-Toleranzen zur Erzeugung der Kante 112 eine Größenordnung haben, die die minimal erreichbare Strukturbreite überschreitet. Durch diese Justage-Toleranzen wird die Soll-Kante 112 der Photomaske 110 von der in Fig. 1A gezeigten Position verschoben. Da die Justage-Toleranz größer ist als die halbe minimale Gatebreite der der in Fig. 1A gezeigten Gatestruktur kann die tatsächliche oder Ist-Kante der Photomaske 110 in den Sourcebereich oder in den LDD-Bereich wandern. Diese Situationen sind in Fig. 1B und 1C dargestellt.

In Fig. 1B ist die Situation gezeigt, in der die tatsächliche Kante 116 der Photomaske 110 aufgrund der Justage-Toleranzen nicht mehr auf der Gatestruktur 108 sondern auf der Oberfläche 106 des Substrats 100 im Bereich des Sourcebereichs 102 liegt, so dass durch die Photomaske 110 ein Abschnitt 118 des Sourcebereichs 102 maskiert ist. In diesem maskierten Abschnitt 118 ist der Sourcebereich während einer nachfolgenden Bearbeitung maskiert, so dass zwar in den Sourcebereich 102 eine Implantation 114 erfolgt, die jedoch nicht bis an das Gate 108 heranreicht.

In Fig. 1C ist die Situation dargestellt, wenn sich die tatsächliche Kante 116 der Photomaske 110 aufgrund der Justage-Toleranzen nicht mehr auf der Gatestruktur 108 befindet, sondern auf der Oberfläche 106 im Bereich des LDD-Bereichs 104 des Substrats angeordnet ist. Hierdurch wird ein Bereich 120 des LDD-Bereichs freigelegt, so dass in einem nachfolgenden, eigentlich dem Sourcebereich 102 vorbehaltenen Prozessschritt, auch dieser Bereich 120 im LDD-Bereich 102 prozessiert wird, so dass beispielsweise auch hier eine Implantation zur Erzeugung eines hochdotierten Bereichs durchgeführt wird, so dass eine zuverlässige Herstellung des MOS-Transistors mit LDD-Bereich nicht gewährleistet ist.

Um die anhand der Fig. 1A bis Fig. 1C beschriebenen Probleme zu vermeiden, wurde im Stand der Technik die Gatelänge so gewählt, dass diese gleich oder größer der Justage-Toleranzen war. Hierdurch wird sichergestellt, dass eine Verschiebung der Soll-Kante 112 der Photomaske 110 aufgrund der Justage-Toleranzen immer noch dazu geführt hat, dass die tatsächlichen Kanten auf der Gatestruktur 108 angeordnet waren.

Der Nachteil dieser Vorgehensweise liegt auf der Hand, da hierdurch die durch die Abbildungsprozesse erreichbaren minimalen Strukturbreiten nicht realisiert werden können, das Gate also breiter gemacht werden musste als dies die Herstellungstechniken zugelassen hätten. Eine minimale Gatelänge ist wünschenswert, um z.B. die Gatekapazität zu minimieren. Ferner hat eine minimale Gatelänge vorteilhafte Auswirkungen auf die Eigenschaften des Transistors, wie z.B. auf die Steilheit, Grenzfrequenz etc.

Ausgehend von diesem Stand der Technik liegt der vorliegenden Erfindung die Aufgabe zugrunde, ein verbessertes Verfahren zur Definition eines freizulegenden Substratbereichs angrenzend an eine Struktur zu schaffen, mit dem eine Struktur mit minimaler Strukturbreite realisierbar ist.

Diese Aufgabe wird durch ein Verfahren gemäß Anspruch 1 gelöst.

Die vorliegende Erfindung schafft ein Verfahren zum photolithographischen Festlegen eines freigelegten Substratbereichs, der direkt an eine auf dem Substrat angeordnete Struktur angrenzt, mit folgenden Schritten:
(a) Aufbringen einer Maskierungsschicht, die bis an die Struktur heranreicht, auf dem Substrat;
(b) Aufbringen einer Photoresistschicht;
(c) photolithographisches Festlegen einer Kante der Photoresistschicht in einer Solllage, die um mindestens eine Justage-Toleranz eines Belichtungsverfahrens von einer Kante der Struktur beabstandet ist, die an einen nicht zu entfernenden Abschnitt der Maskierungsschicht angrenzt, um eine Istlage der Kante der Photoresistschicht zu erhalten, die entweder oberhalb der Struktur oder oberhalb des zu entfernenden Abschnitts der Maskierungsschicht liegt; und
(d) Ätzen der Maskierungsschicht unter Verwendung der im Schritt (c) strukturierten Photoresistschicht, um die Maskierungsschicht bis zu der Struktur zu entfernen.

Gemäß einem bevorzugten Ausführungsbeispiel der vorliegenden Erfindung bezieht sich das Verfahren auf die Herstellung eines MOS-Transistors mit einem LDD-Bereich, wobei durch das erfindungsgemäße Verfahren während der Implantationsschritte die oben erwähnte Trennung zwischen dem Sourcebereich und dem LDD-Bereich sichergestellt werden kann, bei gleichzeitiger Erreichung einer Gatebreite die gleich der minimalen Strukturbreite ist, die mit dem Belichtungsverfahren erreichbar ist, so dass bei gleicher Ausrüstung, die für die im Stand der Technik verwendeten Herstellungsschritte herangezogen wurde, die Erzeugung kürzerer Gates möglich ist.

Gemäß der vorliegenden Erfindung wird dies dadurch erreicht, dass eine sogenannte Hartmaske erzeugt wird, die eine sourceseitige Implantation und eine drainseitige Implantation trennt. Die Hartmaske ist vorzugsweise selektiv zu den darunterliegenden Schichten und selektiv zu dem Gate mittels eines isotropen Ätzschrittes ätzbar.

Gemäß einem bevorzugten Ausführungsbeispiel wird die Gatestruktur vorab auf der Oberfläche des Substrats gebildet, also bevor die Maskierungsschicht aufgebracht wurde, oder die Maskierungsschicht wird zunächst zur Erzeugung der Gatestruktur herangezogen.

Der Vorteil der vorliegenden Erfindung besteht darin, dass nunmehr eine minimale Gatebreite erreichbar ist, da die Hartmaske ohne Justagetoleranzen auf dem Substrat erzeugt wird und selektiv zu den übrigen Materialien des Substrats und der Gatestruktur entfernbar ist.

Vorzugsweise findet die vorliegende Erfindung ihre Anwendung auf MOS-Transistoren, welche einen leicht dotierten Drainbereich zwischen der Gatestruktur und dem eigentlichen Drainbereich aufweisen, wobei dieser LDD-Bereich größer ist als ein Bereich, der durch eine Spacertechnologie erzeugt werden kann. Zwar kann durch die Spacertechnologie ein kurzer LDD-Bereich erzeugt werden, dieser tritt jedoch sourceseitig und drainseitig an der Gatestruktur auf. Diese LDD-Bereiche sind für MOS-Transistoren erforderlich, welche hohe Spannungen halten müssen. Neben den MOS-Transistoren mit einem langen LDD-Bereich, die beispielsweise bei EEPROMs Verwendung finden, die für eine Programmierung etwa 18 V benötigen, wird das erfindungsgemäße Verfahren auch bei LDMOS-Transistoren mit LDD-Bereichen herangezogen. LDMOS-Transistoren sind MOS-Transistoren mit lateral diffundiertem Kanalbereich. Der niedrig dotierte Drainbereich kann entweder implantiert werden, indem z.B. in einem p-Substrat eine n-Implantation eingebracht wird, oder durch eine aufgewachsene n-Epitaxie-Schicht gebildet werden. Die Transistoren mit implantiertem n-Gebiet werden meist im HF-Bereich eingesetzt, wobei das niedrig dotierte Gebiet zur Erhöhung der Durchbruchspannung meist mit einer Dosis von etwa 1 x 10¹² 1/cm² implantiert wird. Das niedrig dotierte Gebiet wird dann als RESURF-Gebiet (RESURF = Reduced Surface Field) bezeichnet.

Die Transistoren mit einer n-Epitaxieschicht werden überwiegend im Bereich der Leistungstransistoren eingesetzt.

Gemäß einem weiteren, bevorzugten Ausführungsbeispiel der vorliegenden Erfindung wird bei einem LDMOS-Transistor, insbesondere für Hochfrequenz-Leistungsanwendungen, die Länge des LDD-Bereichs, der auf einer Seite des Gates angeordnet ist, nicht über die im Stand der Technik herkömmliche Phototechnik bestimmt, sondern unter Ausnutzung des erfindungsgemäßen Verfahrens, so dass die Länge des LDD-Bereichs nicht mehr den Schwankungen der Phototechnik unterworfen ist, so dass auch die damit verbundenen Schwankungen der elektrischen Parameter des LDMOS-Transistors reduziert werden.

Zusätzlich zu den oben beschriebenen Schritten im Zusammenhang mit der Erzeugung der Gatestruktur mit minimaler Strukturbreite wird gemäß diesem Ausführungsbeispiel am späteren Übergang des LDD-Bereichs zum Drainbereich eine weitere Struktur, beispielsweise eine Polystruktur, definiert. Diese Struktur hat eine minimale Breite und zwischen der Gatestruktur und der Drain-Justage-Struktur sowie über den verbleibenden Drainbereich erstreckt sich die Maskierungsschicht. Bei diesem Ausführungsbeispiel wird die Maskierungsschicht über dem zu erzeugenden Drainbereich mit dem oben beschriebenen, erfindungsgemäßen Verfahren bis zu der zusätzlichen Polystruktur hin entfernt. Anschließend erfolgt die Drainimplantation, so dass der Abstand des Drainbereichs zum Gate und damit die Länge des LDD-Bereichs durch die gerade beschriebene Ätzung definiert ist. Der Vorteil dieser Vorgehensweise besteht darin, dass keine Justagetoleranzen zum Gate auftreten, da das Gate als erste Struktur und die Drain-Justage-Struktur gemeinsam erzeugt werden, so dass die im Stand der Technik auftretenden Justageprobleme bei der Anwendung der Phototechnik vermieden werden.

Abhängig von der Weiterbildung des LDMOS-Transistors kann die Polystruktur stehen bleiben und als drainseitige Potentialplatte dienen, sie kann jedoch ebenso mit einem geeigneten Ätzschritt entfernt werden, wobei der Bereich bei diesem Ätzschritt mit einer Phototechnik definiert wird.

Bei einem Ausführungsbeispiel wurde der LDD-Bereich bereits vor Erzeugen der Strukturen auf der Substratoberfläche erzeugt. Wird der LDD-Bereich jedoch erst nach der Erzeugung der Strukturen implantiert, so muss hierfür zunächst die Maskierungsschicht über dem LDD-Bereich entfernt werden.

Bei einem anderen Ausführungsbeispiel ist die weitere Struktur derart gebildet, dass diese den gesamten zu bildenden Drainbereich überdeckt, so dass nur zwischen dem Gate und der Drain-Justage-Struktur die Maskierungsschicht verbleibt. In diesem Fall wird die Polysiliziumstruktur vollständig über dem Drainbereich entfernt, wobei hier die Lackstufe/Lackkante auf dem benachbart liegenden Maskierungsschichtabschnitt liegt, sofern der Ätzprozess des Polysiliziums eine ausreichende Selektivität zu dem Material der Maskierungsschicht, z. B. Oxid, hat. Anschließend erfolgt die Drainimplantation, so dass auch hier der Abstand des Drainbereichs zum Gate und damit die Länge des LDD-Bereichs durch den Ätzschritt definiert ist, wodurch auch hier die Justagetoleranzen vermieden werden.

Mit diesem Ausführungsbeispiel wird erreicht, dass der Abstand von Gate zu Drain nur noch durch die Gate-Phototechnik festgelegt ist, mittels der Strukturen im Gate- und Drainbereich erzeugt werden. Die Phototechnik zum Erzeugen der zwei Strukturen wird gut beherrscht, und bei der im wesentlichen gleichzeitigen Herstellung der Drainstruktur und der Gatestruktur ist der Abstand zwischen denselben sehr gut einstellbar. Hierdurch werden Schwankungen der vom Abstand zwischen Gatebereich und Drainbereich beeinflussten elektrischen Parameter vermieden.

Bei einer weiteren Ausgestaltung dieses Ausführungsbeispiels kann das gerade beschriebene Verfahren ferner zur selbstjustierten Definition eines Drainkontakts verwendet werden, wobei hierzu ein verbleibendes Gateoxid im Drainbereich abgeätzt wird. Gleichzeitig kann in diesem Fall das Oxid im Sourcebereich entfernt werden, so dass der Sourcekontakt bis an das Gate heranreicht.

Gemäß einem weiteren Ausführungsbeispiel der vorliegenden Erfindung ist es möglich, die Festlegung eines Abstands zwischen Gate- und Sourcekontakt ebenfalls selbstjustiert einzustellen, wobei ein solcher sourceseitiger Widerstand bei Leistungs-LDMOS-Transistoren im HF-Bereich Verwendung findet. Die Vorgehensweise ist ähnlich zu dem oben beschriebenen Ausführungsbeispiel, bei dem eine weitere Struktur im Drainbereich angeordnet ist. Auch hier wird eine weitere Struktur, beabstandet von dem Gatebereich, auf dem zukünftigen Sourcebereich angeordnet, beispielsweise eine Polysilizium-Struktur. Nach der Strukturierung des Gates wird diese entfernt, wodurch ein erwünschter Abstand vor dem Gate mit einer Oxid-Nitrid-Schicht bedeckt ist, der Sourcebereich jedoch nur mit einem Gateoxid bedeckt ist. Dieses wird selektiv entfernt, so dass eine Position des Sourcekontakt ebenfalls selbstjustiert zum Gate eingestellt wird.

Bevorzugte Ausgestaltungen der vorliegenden Erfindung sind in den Unteransprüchen definiert.

Nachfolgend werden anhand der beiliegenden Zeichnungen bevorzugte Ausführungsbeispiele der vorliegenden Erfindung näher erläutert. Es zeigen:
Fig. 1A eine beispielhafte Halbleiterstruktur mit einer Photomaske mit zugeordneter Soll-Kante,
Fig. 1B eine beispielhafte Halbleiterstruktur gemäß Fig. 1A mit der tatsächlichen Photomaskenkante auf einem Sourcebereich,
Fig. 1C die in Fig. 1A gezeigte Halbleiterstruktur bei der die tatsächliche Photomaskenkante auf dem LDD-Bereich ist,
Fig. 2A-2K ein erstes Ausführungsbeispiel zur Herstellung eines LDMOS-Transistors mit LDD-Bereich unter Verwendung des erfindungsgemäßen Verfahrens;
Fig. 3A-3N ein zweites Ausführungsbeispiel der Herstellung eines LDMOS-Transistors mit LDD-Bereich unter Verwendung des erfindungsgemäßen Verfahrens;
Fig. 4 ein Beispiel für die Erzeugung einer Gatestruktur mit einer Abmessung unterhalb der minimalen Strukturbreite mit LDD-Bereich unter Verwendung des erfindungsgemäßen Verfahrens;
Fig. 5A-D ein drittes Ausführungsbeispiel zur Herstellung eines LDMOS-Transistors mit LDD-Bereich, bei dem am Übergang von LDD-Bereich zu Drainbereich eine weitere Polystruktur gemäß einer ersten Variante vorgesehen ist;
Fig. 6A-C ein viertes Ausführungsbeispiel der Herstellung eines LDMOS-Transistors mit LDD-Bereich, bei dem an einem Übergang von LDD-Bereich zu Drainbereich eine Polystruktur gemäß einer zweiten Variante vorgesehen ist; und
Fig. 7A-C ein fünftes Ausführungsbeispiel der Herstellung eines LDMOS-Transistors mit LDD-Bereich, bei dem ein Source-Kontaktbereich selbstjustiert hergestellt wird.

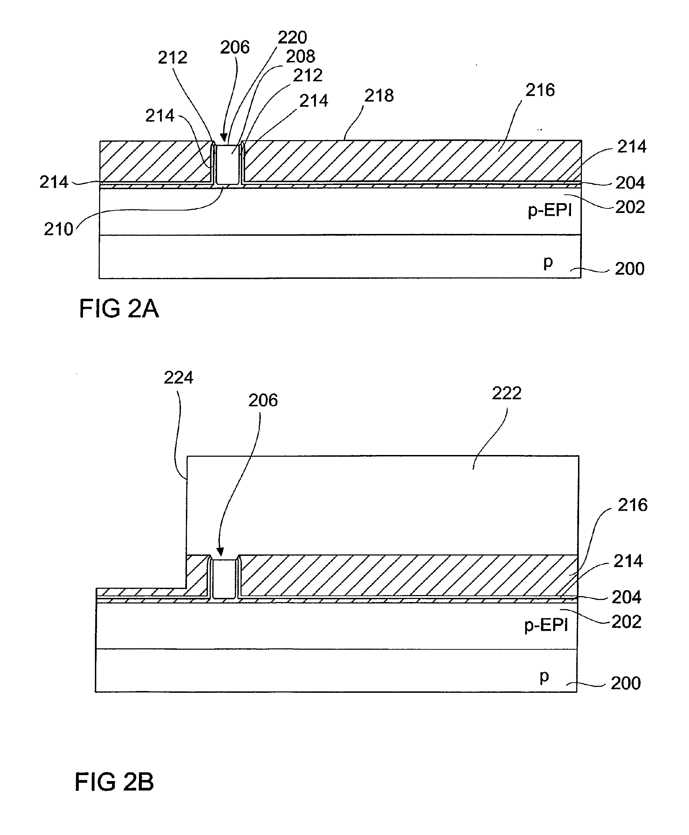

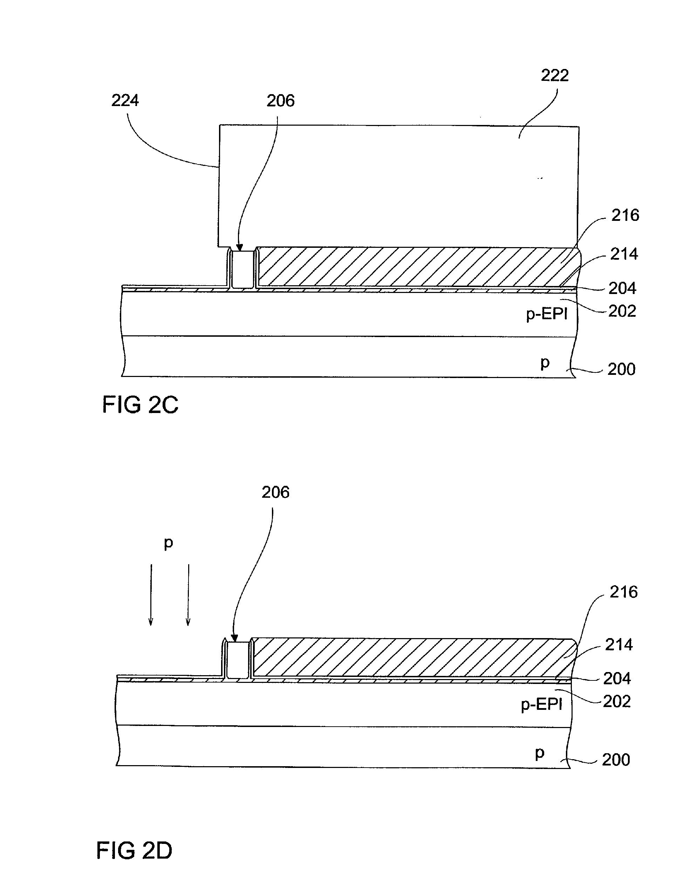

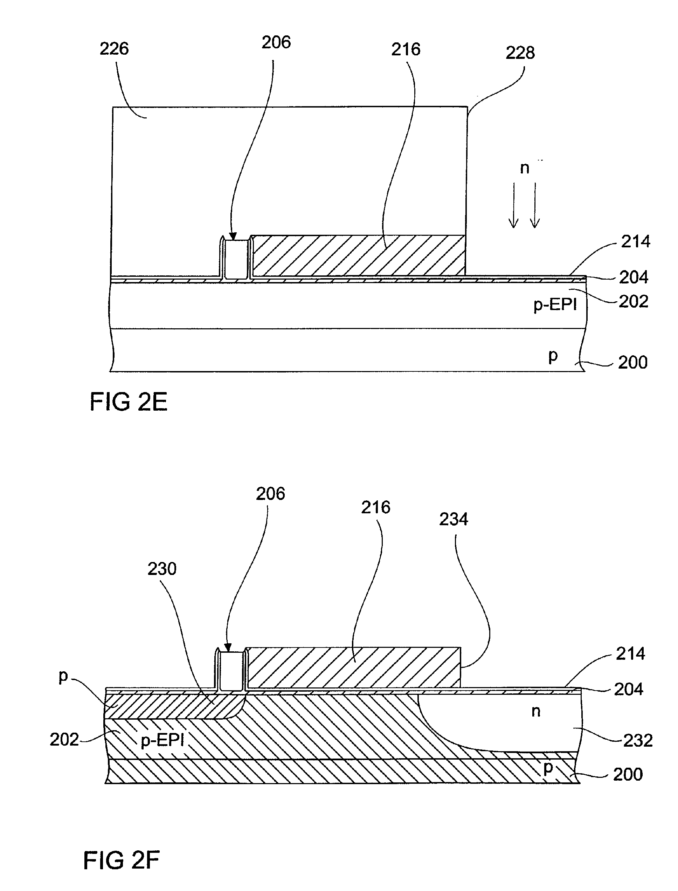

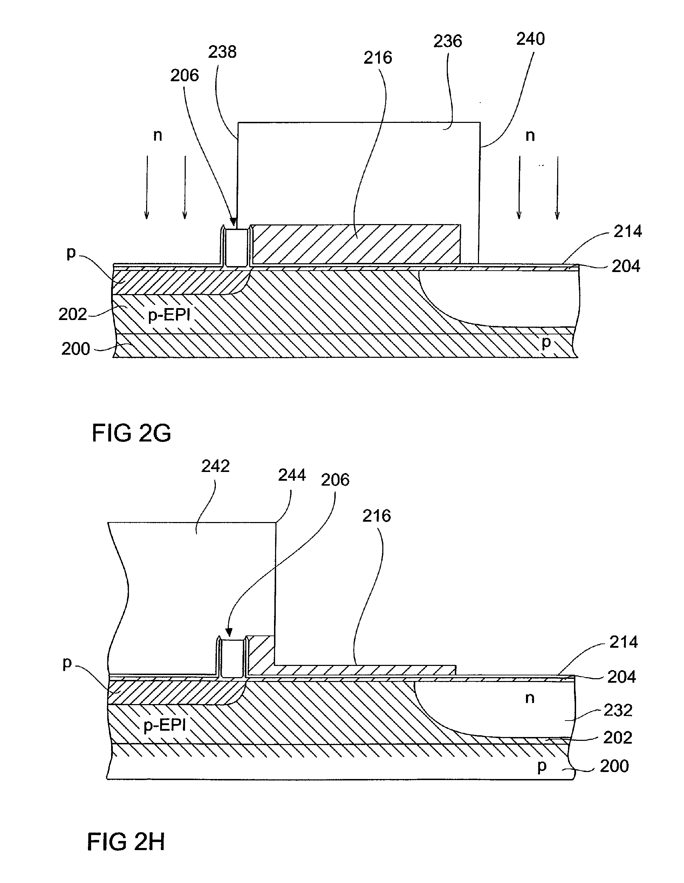

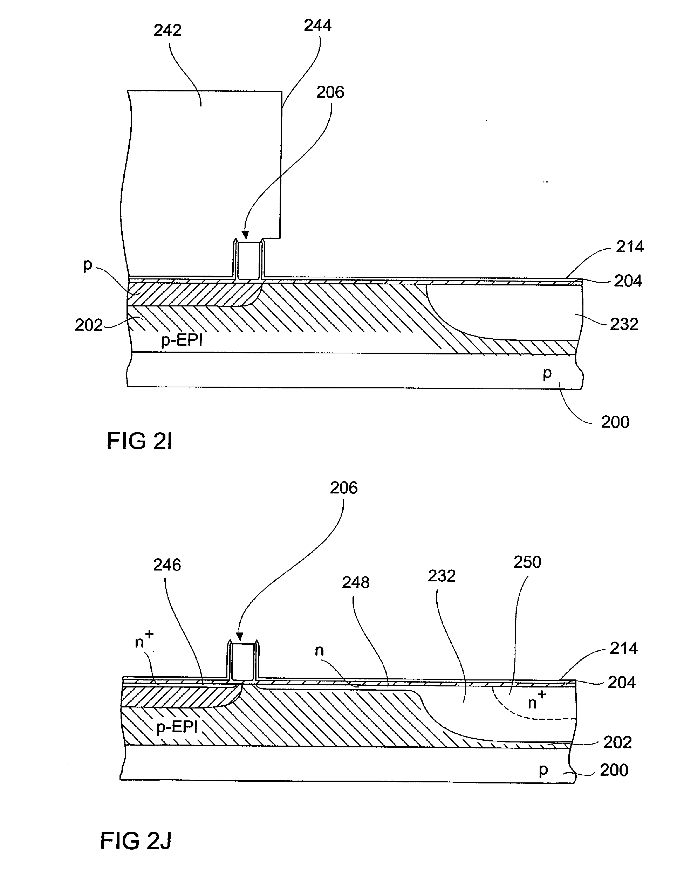

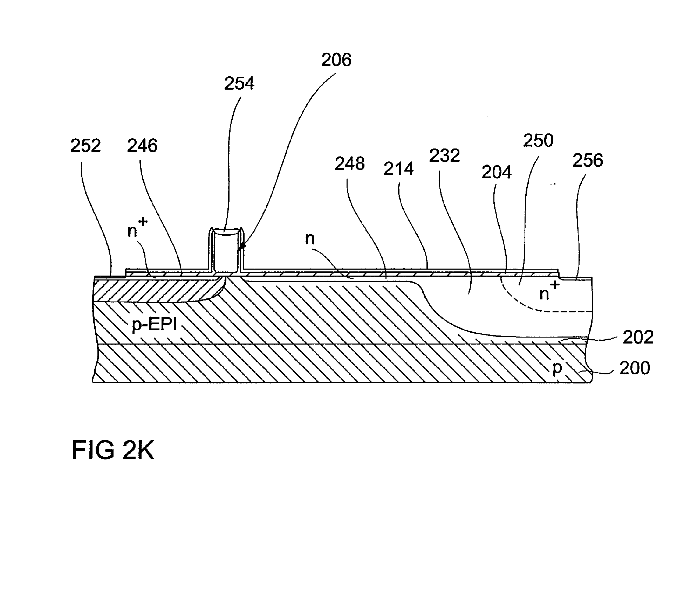

Anhand der Fig. 2 wird nachfolgend ein erstes bevorzugtes Ausführungsbeispiel zur Herstellung eines LDMOS-Transistors mit LDD-Bereich beschrieben, welches das erfindungsgemäße Verfahren zum Freilegen eines Substratbereichs verwendet. Anhand der Fig. 2A-2K werden die einzelnen Schritte zur Herstellung des LDMOS-Transistors näher erläutert.

Bei dem in Fig. 2 beschriebenen Ausführungsbeispiel wird von einer Struktur ausgegangen, bei der eine Gatestruktur bereits auf einem Substrat gebildet ist. In Fig. 2A ist ein p-Substrat 200 gezeigt, auf dem eine p-Epitaxieschicht 202 abgeschieden wurde. Auf der dem Substrat 200 abgewandten Oberfläche der Epitaxieschicht 202 ist eine erste Oxidschicht 204 gebildet. Auf der Epitaxieschicht 202 ist eine Gatestruktur 206 gebildet, die einen Gatepolysiliziumabschnitt 208 und einen Gateoxidabschnitt 210 umfasst, wobei der Gateoxidabschnitt 210 durch den unterhalb des Gatepolysiliziumabschnitts liegenden Teils der ersten Oxidschicht 204 gebildet ist. Die Seitenwände des Gatepolysiliziumabschnitts 208 sind ebenfalls mit Oxidschichten 212 bedeckt. Auf der ersten Oxidschicht 204 sowie auf den seitlichen Oxidschichten 212 ist eine Ätzstoppschicht 214, beispielsweise eine dünne Nitrid-Schicht, abgeschieden. Auf der Nitridschicht 214 ist die Hartmaske 216 gebildet, die aus einer Oxidschicht hergestellt ist. Wie aus Fig. 2A zu erkennen ist, wurde zu beiden Seiten der Gatestruktur 206 die Schicht 216 aufgebracht, die lückenlos an das Gate 206 heranreicht, jedoch durch das Gate 206 unterbrochen ist. Zwischen der Gatestruktur 206 und der Hartmaske 216 sind die Nitridschicht 214 und die Oxidschicht 212 angeordnet.

Es wird darauf hingewiesen, dass eine Oberkante 218 der Hartmaske 216 nicht mit einer Oberkante 220 der Gatestruktur 206 übereinstimmen muss.

Die Hartmaske 216 wird erzeugt, indem auf die Oberfläche der Oxidschicht 204 sowie auf die seitlichen Oxidschichten 212 die dünne Nitrid-Schicht 214 als Ätzstopp aufgebracht wird und anschließend eine Oxidschicht abgeschieden wird. Der tiefste Punkt der abgeschiedenen Oxidschichtoberfläche liegt hierbei über der Oberkante 220 des Gatepolysiliziumabschnitts 208 der Gatestruktur 206. Die so erzeugte Oxidschicht wird anschließend mittels eines CMP-Verfahren (CMP = Chemical Mechanical Polishing = Chemisch-Mechanisches-Polier-Verfahren) bis zur Oberkante 220 des Gatepolysiliziumabschnitts 208 eingeebnet, so dass sich die in Fig. 2A dargestellte Struktur ergibt.

In einem anschließenden Schritt wird eine Lackschicht, beispielsweise eine Photoresistschicht aufgebracht, und anschließend wird eine Kante der Photoresistschicht in einer Solllage photolithographisch festgelegt. Die Solllage ist um mindestens eine Justage-Toleranz eines Belichtungsverfahrens von einer Kante der Gatestruktur, die an einen nicht zu entfernenden Abschnitt der Hartmaske angrenzt, beabstandet, um so eine Istlage der Kante der Photoresistschicht zu erhalten, die entweder oberhalb der Gatestruktur oder oberhalb des zu entfernenden Abschnitts der Hartmaske liegt. Anschließend wird, unter Verwendung der strukturierten Photoresistschicht die Hartmaske geätzt, um dieselbe bis zu der Gatestruktur hin zu entfernen. In Fig. 2B ist die aus Fig. 2A bekannte Halbleiterstruktur dargestellt, bei der auf die freiliegenden Oberflächen der Hartmaske 216 und der Gatestruktur 206 eine Lackschicht (Photoresistschicht) 222 aufgebracht wurde, die derart strukturiert wurde, dass deren tatsächliche Kante 224 etwas in den Sourcebereich der zu erzeugenden LDMOS-Struktur hineinreicht, der bei dem in Fig. 2 beschriebenen Ausführungsbeispiel in den Figuren links von der Gatestruktur 206 angeordnet ist. Alternativ kann die tatsächliche Kante 224 der Lackschicht 222 auch mit der sourceseitigen Kante der Gatestruktur 206 abschließen oder auf der Gatestruktur angeordnet sein, sofern sichergestellt ist, dass Justage-Toleranzen bei der Erzeugung der Kante 224 nicht dazu führen, dass diese in einem drainseitigen Bereich der zu erzeugenden LDMOS-Halbleiterstruktur angeordnet sind, welcher bei den in Fig. 2 beschriebenen Ausführungsbeispielen rechts von der Gatestruktur 206 angeordnet ist.

Fig. 2B zeigt ferner dass ein Bereich der Hartmaske 216 mittels eines anisotropen Ätzschrittes bereits teilweise entfernt wurde.

Fig. 2C zeigt die Halbleiterstruktur nach dem Abschluss des Ätzens der Hartmaske 216, und wie zu erkennen ist, ist der sourceseitige Bereich der Hartmaske 216 vollständig bis zu der Gatestruktur 206 hin entfernt. Durch diese isotrope Ätzung wurde die Schicht auf der Sourceseite bis zum Gate hin entfernt. Hierzu muss für die Schicht 216 ein Material ausgewählt sein, das eine geeignete Selektivität zu denjenigen Bereichen aufweist, die erhalten bleiben sollen. Alternativ ist es auch möglich dünne Schichten, wie beispielsweise die Ätzstoppschicht 214 zwischen den zu schützenden Bereichen und der Schicht 216 aufzubringen, wobei die Schicht 214 eine geeignete Selektivität hat.

Anschließend wird die Lackschicht entfernt, so dass sich die in Fig. 2D gezeigte Struktur ergibt. Ferner erfolgt eine Implantation des Kanalmaterials durch eine Implantation von p-Material, wie dies durch die Pfeile in Fig. 2D dargestellt ist, wobei die Hartmaske 216 im Drainbereich (in der Fig. rechts von der Gatestruktur 206) als Hartmaske dient.

In einem nachfolgenden, optionalen Schritt werden die Vorbereitungen für die Erzeugung eines sogenannten Drainbuffers durchgeführt. Hierbei wird mittels Phototechnik der Drainbereich festgelegt und im Bereich des späteren Drainanschlusses freigeätzt. Anschließend erfolgt eine Implantation eines n-Materials mit einer Dotierung, die zwischen einer Dotierung der noch zu erzeugenden Drainimplantation und dem noch zu erzeugenden LDD-Bereich liegt. In Fig. 2E ist die Halbleiterstruktur gezeigt, auf der eine weitere strukturierte Lackschicht 226 angeordnet ist, deren Kante 228 den freizulegenden Bereich des Drainanschlusses definiert, in dem nach dem Strukturieren der Lackschicht 226 die Hartmaske 216 im freigelegten Bereich des Drainanschlusses, vorzugsweise anisotrop geätzt wird. Anschließend erfolgt die Implantation der erforderlichen Dotierung, wie dies durch die Pfeile in Fig. 2E gezeigt ist, um in einem späteren Schritt den Drainbuffer mit einer Dotierung die zwischen der Dotierung des LDD-Bereichs und der Dotierung des zukünftigen Drainimplantationsbereichs liegt, zu erzeugen. Wie aus Fig. 2E zu erkennen ist, ist für diese Implantation im Bereich des Drainanschlusses der Sourcebereich mit dem Photolack 226 abgedeckt. Nach der Implantation wird der Photolack 226 entfernt.

Anschließend wird ein Temperaturschritt durchgeführt, um die im Sourcebereich eingebrachte p-Implantation unter die Gatestruktur 206 zu treiben, um die Einsatzspannung des herzustellenden LDMOS-Transistors einzustellen. Gleichzeitig erfolgt während dieses Temperaturschrittes auch eine Diffusion der im vorhergehenden Schritt erfolgten Drainbufferimplantation unter die Hartmaske 216. Die sich ergebende Struktur ist in Fig. 2F dargestellt. Wie zu erkennen ist, wurde der p-Bereich unter die Gatestruktur 206 diffundiert, um dort den p-Kanalbereich 230 zu bilden. Ebenso wurde der Drainbuffer 232 erzeugt, der sich ausgehend von einer Kante 234 der Hartmaske 216 im Bereich des zukünftigen Drainanschlusses unter die Hartmaske 216 erstreckt.

Nachfolgend wird unter Verwendung einer Photolithographietechnik der Sourcebereich und der Drainbereich definiert und eine entsprechende Implantation wird durchgeführt. Wie in Fig. 2G zu erkennen ist, wurde eine weitere Lackschicht 236 auf die freiliegenden Oberfläche der in Fig. 2F dargestellten Struktur aufgebracht und derart strukturiert, dass eine erste Kante 238 der Lackschicht 236, welche dem Sourcebereich zugewandt ist, auf der Gatestruktur 206 angeordnet ist. Eine zweite Kante 240 der Lackschicht 236 ist dem Drainbereich zugewandt und ist auf der Oberfläche der Nitridschicht 214 angeordnet, so dass die Hartmaske 216 vollständig von der Photoschicht 236 bedeckt ist. Wie durch die Pfeile in Fig. 2G angedeutet ist, erfolgt anschließend eine Implantation eines n-Materials für die spätere Bildung des Sourcebereichs und des Drainbereichs. Anschließend wird die Lackschicht 236 wieder entfernt.

In einem nachfolgenden Schritt wird eine weitere Photoresistschicht auf das Substrat aufgebracht, und eine Kante dieser Photoresistschicht wird photolithographisch in einer Solllage festgelegt, wobei diese Solllage mindestens um eine Justage-Toleranz eines Belichtungsverfahrens von einer Kante der Gatestruktur beabstandet ist, die an einen Abschnitt der Hartmaske zwischen der Gatestruktur und dem Sourcebereich angrenzt, um eine Istlage der Kante der Photoresistschicht zu erhalten, die entweder oberhalb der Gatestruktur oder oberhalb des Abschnitts der Maskierungsschicht zwischen der Gatestruktur und dem Drainbereich liegt. Anschließend erfolgt ein Ätzen der freigelegten Abschnitte der Schicht 216. In Fig. 2H ist die sich während eines ersten anisotropen Ätzschrittes einstellende Struktur gezeigt. Wie zu erkennen ist, wurde eine Photoschicht 242 aufgebracht, die derart strukturiert wurde, dass eine Kante 244 derselben auf der Maskierungsschicht 216 angeordnet ist. Der Abstand der Kante 244 wurde derart eingestellt, dass sichergestellt ist, dass selbst bei minimaler Breite der Gatestruktur 206 die Kante 244 auf dem Gate 206 oder, wie gezeigt, auf der Schicht 216 angeordnet ist, so dass also die sourceseitigen Bereiche der Struktur sicher durch die Photoresistschicht 242 abgedeckt sind. In Fig. 2H ist die Situation nach einem anfänglichen anisotropen Ätzschritt gezeigt, in der bereits ein Teil der Schicht 216 entfernt wurde. Durch einen weiteren, isotropen Ätzschritt wird die Schicht 216 vollständig, bis zur Gatestruktur 206 hin entfernt, so dass sich die in Fig. 2I gezeigte Halbleiterstruktur ergibt.

Anschließend wird die Photoschicht 242 entfernt und der LDD-Bereich wird ganzflächig implantiert. Bei Verwendung einer Dosis von etwa 1 x 10¹² 1/cm² wird dies als Resurf-Gebiet bezeichnet (Resurf = Reduced Surface Field). Hierdurch wird in den Bereich zwischen der Gatestruktur 206 und dem Drainbuffer 232 die erforderliche n-Dotierung für den LDD-Bereich eingebracht. Anschließend wird die so erzeugte Halbleiterstruktur ausgeheilt, so dass sich die in Fig. 2J dargestellte Struktur ergibt. Durch den Ausheil-Schritt werden die Source-, LDDund Drainbereiche gebildet. Wie in Fig. 2J zu erkennen ist, wurde durch das Ausheilen der n⁺-Sourcebereich 246, der n-LDD-Bereich 248 und der n⁺-Drainbereich 250 erzeugt. Zwischen dem Drainbereich 250 und dem LDD-Bereich 248 ist der bereits erzeugte Drainbuffer 232 angeordnet.

Unter Verwendung herkömmlicher Prozessschritte gemäß dem Standardprozess für einen LDMOS-Transistor wird die in Fig. 2J dargestellte Halbleiterstruktur fertiggestellt, und in Fig. 2K ist diese Struktur dargestellt, bei der, verglichen mit Fig. 2J, der Sourcebereich 246 einen Silizidkontakt 252, die Gatestruktur 206 eine Silizidfläche 254, und der Drainanschluss 250 eine Silizidfläche 256 umfasst.

Das p-Substrat 200 ist mit etwa 5 x 10¹⁸ 1/cm³ dotiert, und die p-Epitaxieschicht 202 ist im Bereich von 1,5 x 10¹⁵ 1/cm³ dotiert. Die Diffusion der eingebrachten p-Implantation im Sourcebereich führt zu einer p-Dotierung im Sourcebereich und im Kanalbereich die zwischen 10¹⁵ und 10¹⁸ 1/cm³ liegt. Die eingebrachte Implantation im Drainbereich und die Diffusion des Drainbuffers führt zu einer n-Dotierung in diesem Bereich zwischen 10¹⁵ und 10¹⁹ 1/cm³. Die abschließende Ausheilung der Halbleiterstruktur führt zu einer p-Dotierung im Sourcebereich im Bereich von etwa 10¹⁹ bis 10²⁰ 1/cm³. Im n-LDD-Bereich liegt die n-Dotierung im Bereich von 10¹⁵ bis 10¹⁶ 1/cm³. Im Drainbuffer liegt die n-Dotierung zwischen 10¹⁵ und 10¹⁹ 1/cm³, und die Drain weist eine Dotierung im Bereich 10¹⁹ bis 10²⁰ 1/cm³ auf.

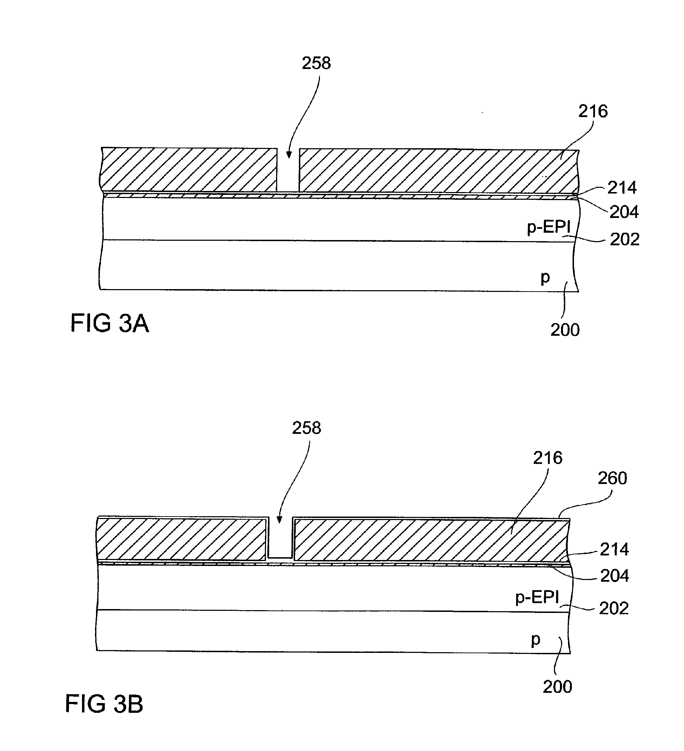

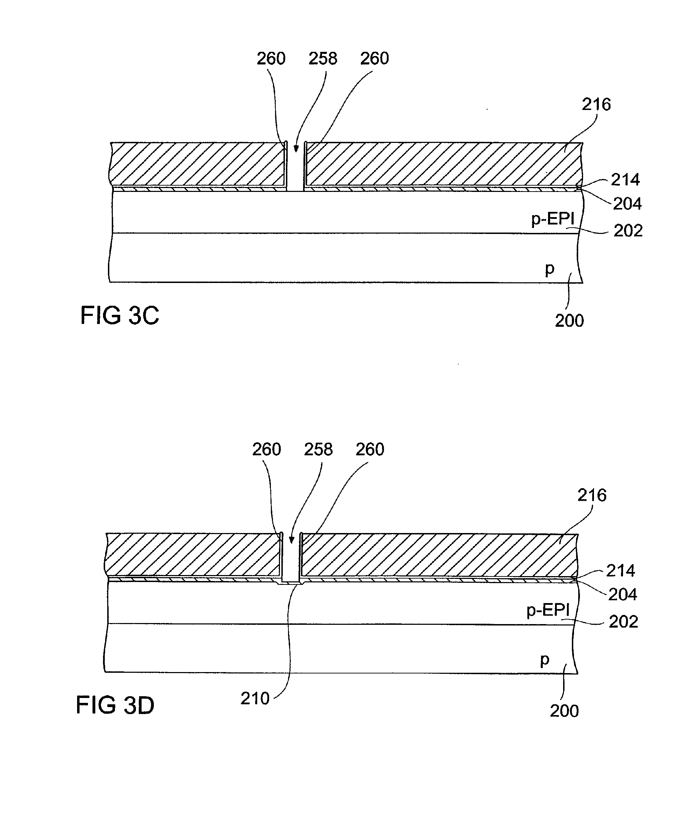

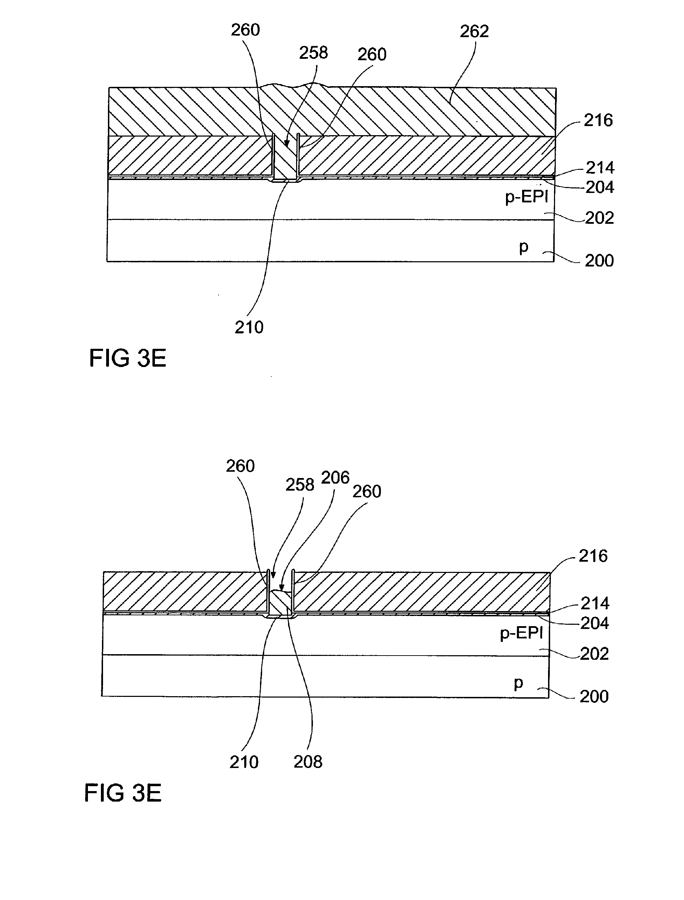

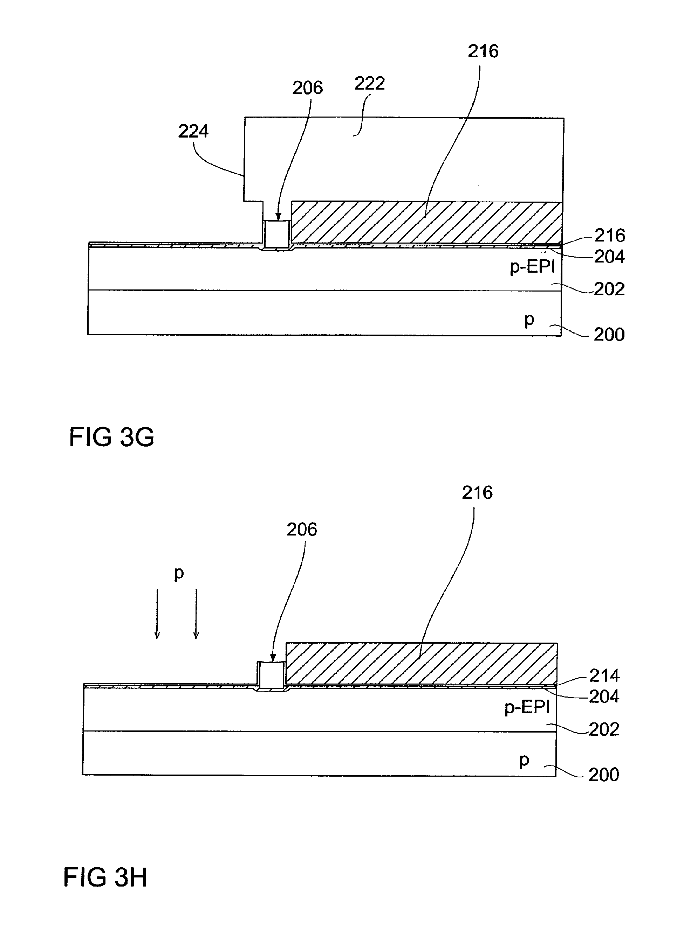

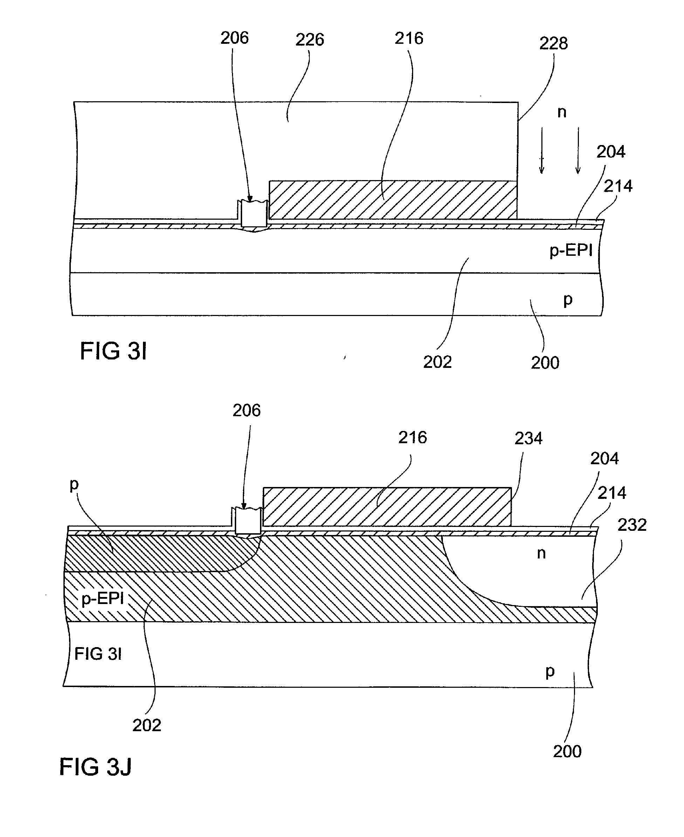

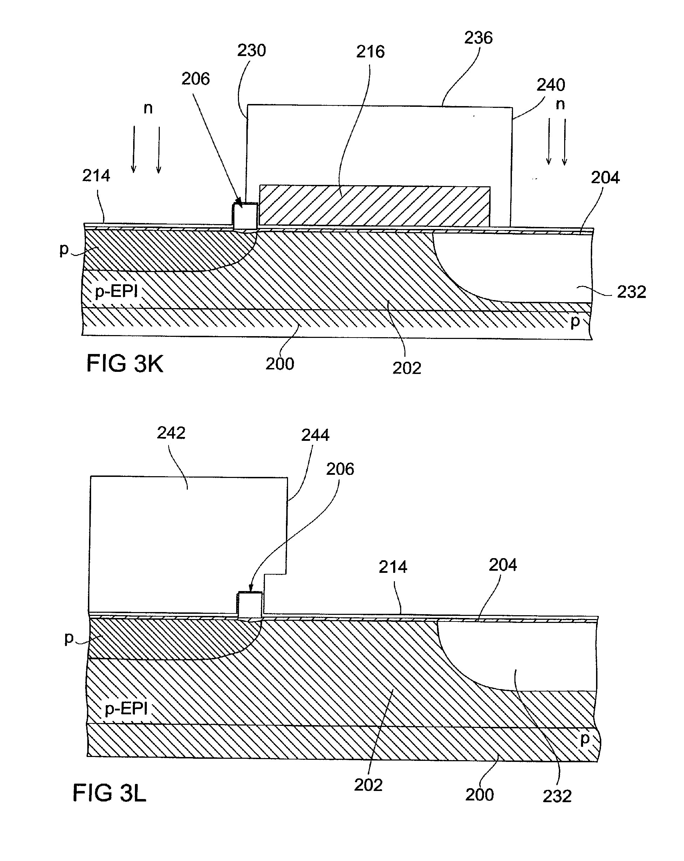

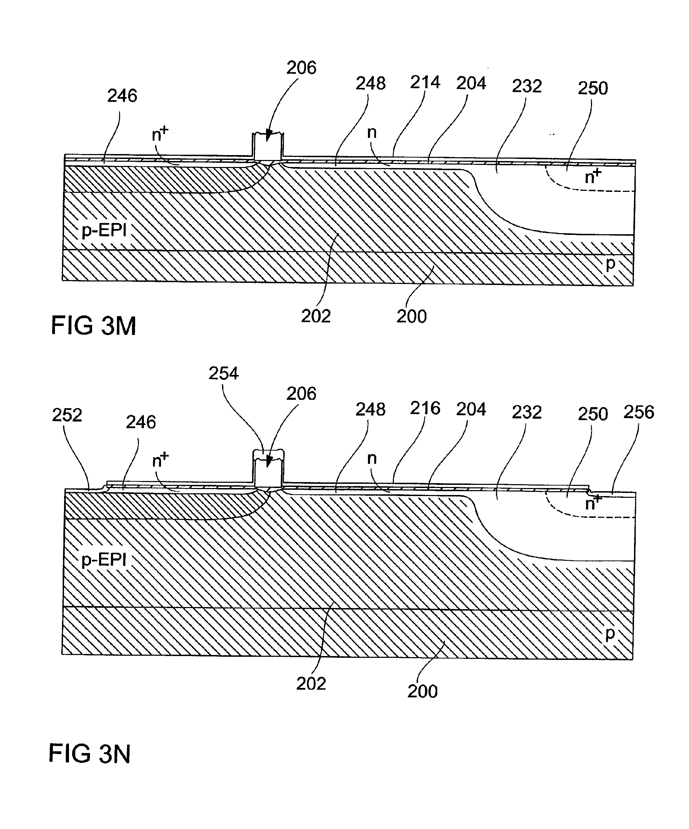

Nachfolgend wird anhand der Fig. 3 ein weiteres Ausführungsbeispiel zur Herstellung eines LDMOS-Transistors beschrieben, welches das erfindungsgemäße Verfahren zum Freilegen eines Substratbereichs umfasst.

Anders als bei dem in Fig. 2 beschriebenen Ausführungsbeispiel wird bei dem Ausführungsbeispiel gemäß Fig. 3 die Gatestruktur unter Verwendung der Hartmaske mittels eines inversen Gateprozesses erzeugt. Es wird darauf hingewiesen, dass bei der nachfolgenden Beschreibung der einzelnen Verfahrensschritte in Fig. 3 Elemente, die bereits anhand der Fig. 2 beschriebenen wurde, mit gleichen Bezugszeichen versehen sind. Ferner wird darauf hingewiesen, dass bis zum Prozessstand in Fig. 3A der LDMOS-Transistor entsprechend Standardprozessen für die LDMOS-Transistorherstellung erzeugt wird.

In Fig. 3A ist ein p-Substrat 200 gezeigt, auf dem eine p-Epitaxieschicht 202 aufgebracht ist. Auf die freiliegende Oberfläche der p-Epitaxieschicht 202 wurde eine Oxidschicht 204 aufgebracht, auf die eine dünne Siliziumnitridschicht 214 aufgebracht wurde. Auf der freiliegenden Oberfläche der Siliziumnitridschicht 214 wurde die Maskierungsschicht 216, beispielsweise eine SiO₂-Schicht, aufgebracht. In die Maskierungsschicht oder Hartmaske 216 wurde ein Graben 258 geätzt, der von der freiliegenden Oberfläche der Hartmaske 216 bis zu der Nitridschicht 214 reicht.

In einem nachfolgenden, optionalen Schritt kann vorgesehen sein, eine weitere Nitridschicht abzuscheiden, um so die Selektivität bei späteren Ätzprozessen zu verbessern. In Fig. 3B ist die weitere, dünne Nitridschicht 260 gezeigt, die auf der freiliegenden Oberfläche der Maskierungsschicht 216, auf den Seitenwänden des Grabens 258 sowie auf der durch den Graben 258 freigelegten Nitridschicht 214 angeordnet ist. In einem nachfolgenden, anisotropen Ätzschritt wird die in Fig. 3B gezeigte weitere dünne Nitridschicht 260 auf der dem Substrat abgewandten Oberfläche der Maskierungsschicht 216 sowie im Bodenbereich des Grabens 258 entfernt. Durch den anisotropen Ätzschritt wird gleichzeitig die Oxidschicht 204 und die Nitridschicht 214 im Bereich des Bodens des Grabens 256 entfernt, so dass der Graben von der nunmehr freiliegenden Oberfläche der Maskierungsschicht 216 bis zu der p-Epitaxieschicht 202 reicht, wie dies in Fig. 3C gezeigt ist. Auf den Seitenwänden des Grabens 258 ist die weitere dünne Nitridschicht 260 aufgrund des anisotropen Ätzvorgangs erhalten geblieben.

Durch eine thermische Oxidation wird in einem nachfolgenden Schritt das durch den vorhergehenden Ätzvorgang entfernte Oxid im Bodenbereich des Grabens erzeugt (erneuert), um so das zukünftige Gateoxid zu erzeugen. In Fig. 3D ist die sich ergebende Struktur nach der thermischen Oxidation dargestellt, und im Bodenbereich des Grabens 258 hat sich der Gateoxidabschnitt 210 gebildet.

Anschließend wird, wie in Fig. 3E gezeigt ist, das Gatematerial 262, z. B. Polysilizium auf der Oberfläche der in Fig. 3D gezeigten Struktur derart abgeschieden, dass der Graben vollständig ausgefüllt ist.

Anschließend wird das Gatematerial 262 zurückgeätzt, so dass, wie in Fig. 3F dargestellt ist, im Graben 258 noch das Gatematerial als Gatematerialabschnitt 208, z. B. Polysilizium, vorhanden ist. Die dem Substrat abgewandte Oberfläche der Hartmaske 216 muss vollständig freigelegt sein, es darf sich also kein Gatematerial 262 nach dem Ätzschritt mehr auf derselben befinden. Um dies zu erreichen, ist es erforderlich, dass der Ätzprozess die Hartmaske 216 schwerer ätzt als das Gatematerial 262.

Durch die anhand der Fig. 3A bis 3F beschriebenen Verfahrensschritte wurde die in 3F gezeigte Gatestruktur 206 gebildet, die im wesentlichen der in Fig. 2A gezeigten Gatestruktur entspricht.

Die im nachfolgenden anhand der Fig. 3G bis 3N beschriebenen Verfahrensschritte entsprechen den bereits anhand der Fig. 2C bis 2K beschriebenen Verfahrensschritte, so dass eine erneute Beschreibung derselben nicht mehr erfolgt. Durch die Verfahrensschritte wird auch hier sichergestellt, dass bei der Herstellung der Implantationen in den entsprechenden Gebieten links und rechts von der Gatestruktur 206 die erforderliche Trennung sichergestellt ist.

Obwohl anhand der Fig. 2 und 3 Ausführungsbeispiele beschrieben wurden, bei denen der LDD-Bereich gegen Ende des Herstellungsprozesses erzeugt wird (siehe Fig. 2I und Fig. 3L) kann bei einem alternativen Ausführungsbeispiel der LDD-Bereich bereits vor der Erzeugung der Gatestruktur implantiert werden. Auch hier ist die durch das erfindungsgemäße Verfahren bereitgestellte Trennung noch erforderlich, um zu vermeiden, dass der schwach dotierte LDD-Bereich während einer Sourceimplantation und einer Kanalimplantation höher dotiert wird als dies erwünscht ist.

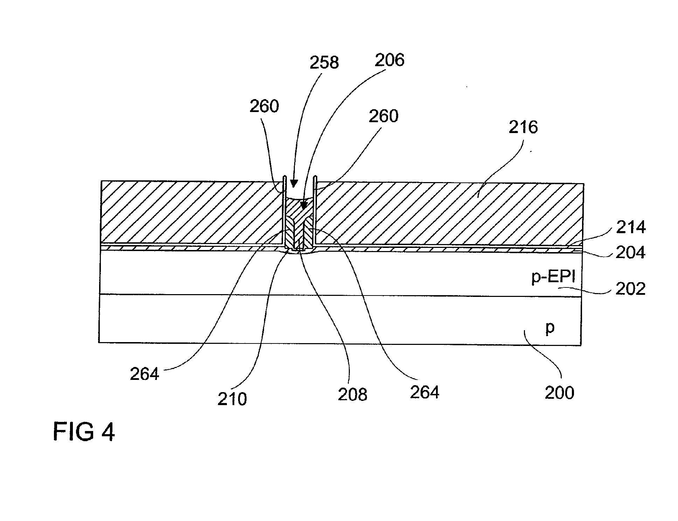

Nachfolgend wird anhand der Fig. 4 ein Ausführungsbeispiel beschrieben, welches es ermöglicht, die durch das erfindungsgemäße Verfahren erreichbare minimale Strukturbreite der Gatestruktur noch weiter zu reduzieren, so dass Gatelängen erreichbar sind, die kürzer als die durch das Abbildungsverfahren erreichbare Minimalstruktur sind.

Hierzu wird bei dem Ausführungsbeispiel gemäß Fig. 3 nach dem Erneuern des Gateoxids (siehe Fig. 3D) und vor dem Abscheiden des Gatematerials (siehe Fig. 3E) eine Oxidschicht abgeschieden, welche anschließend anisotrop zurückgeätzt wird. Dies führt dazu, dass, wie in Fig. 4 gezeigt ist, im Graben 258 sogenannte Spacer 264 erzeugt werden. Diese Spacer 264 bewirken im nachfolgenden Schritt des Aufbringens des Polysiliziums 262 und des entsprechenden Zurückätzens desselben, dass die Gatelänge, also der unter dem Gatematerial 208 liegende Bereich des Gateoxids 210 kürzer ist als die lithographische Länge. Die vorab gebildete dünne Nitridschicht 260, deren Reste auf den Wänden des Grabens 258 verblieben sind, schützen hierbei die Spacer 264 während der isotropen Ätzschritte der Hartmaske 216.

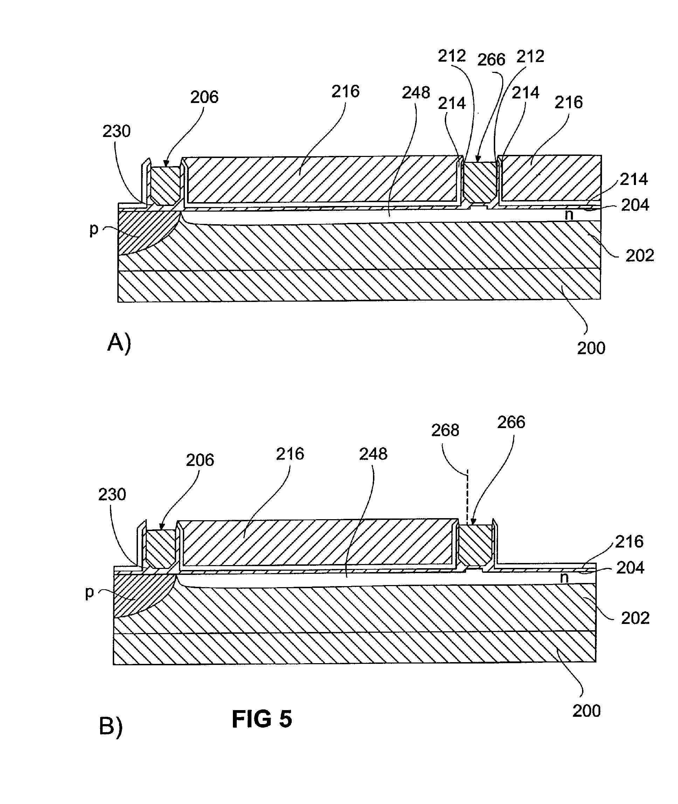

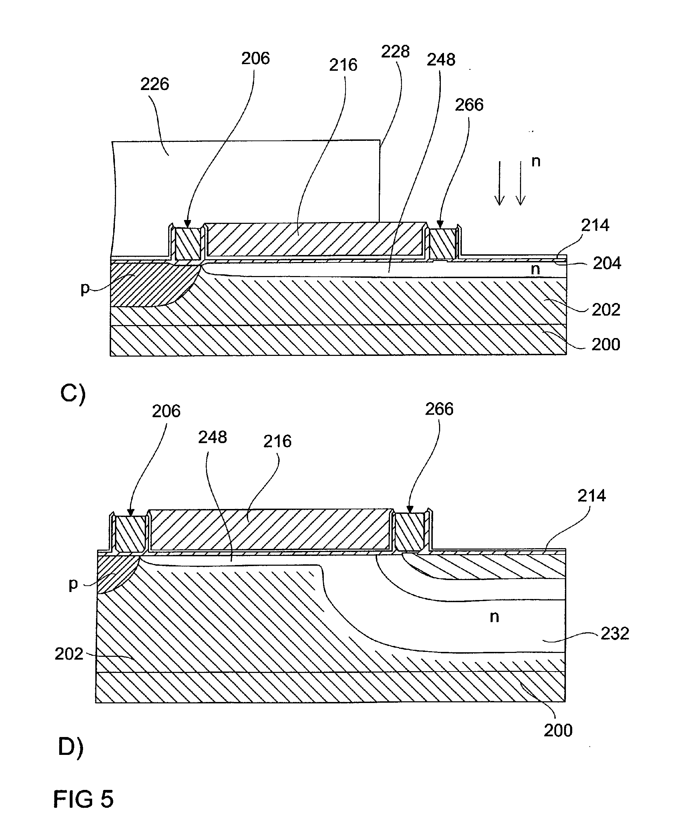

Anhand der Fig. 5 bis 7 werden nachfolgend weitere, bevorzugte Ausführungsbeispiele zur Herstellung eines LDMOS-Transistors beschrieben, welche die erfindungsgemäßen Prinzipien verwenden. Hinsichtlich der Beschreibung der weiteren Ausführungsbeispiele wird darauf hingewiesen, dass in den weiteren Figuren diejenigen Elemente, die bereits anhand der vorhergehenden Figuren beschrieben wurden mit gleichen Bezugszeichen versehen sind.

Bei den anhand der Fig. 5 bis 7 beschriebenen Ausführungsbeispielen wird von einer Struktur ausgegangen, die ähnlich zu der ist, die in Fig. 2D bzw. in Fig. 3H gezeigt ist. Anders als bei den anhand der Fig. 2 und 3 beschriebenen Ausführungsbeispiele ist hier eine Struktur gezeigt, bei der der LDD-Bereich bereits vor der Erzeugung der Gatestruktur implantiert wurde. Selbstverständlich kann auch hier eine Vorgehensweise gewählt werden, wie sie oben anhand der Fig. 2 und 3 beschrieben wurde, nämlich die Erzeugung des LDD-Bereichs gegen Ende des Herstellungsprozesses.

In Fig. 5A ist, wie schon erwähnt, eine Struktur ähnlich zu der in Fig. 2D bzw. 3H gezeigten Struktur, wobei als Unterschied eine weitere Struktur 266 gezeigt ist, die im folgenden auch als Drain-Justage-Struktur bezeichnet wird. Bei dem in Fig. 5 gezeigten Ausführungsbeispiel ist die Drain-Justage-Struktur im wesentlichen identisch zu der Gatestruktur 206 und besteht auch hier vorzugsweise aus einem Polysiliziummaterial. Ähnlich wie bei der Gatestruktur 206 sind die Seitenwände des Polysiliziummaterials der Drain-Justage-Struktur 266 mit Oxidschichten 212 bedeckt, auf denen wiederum Abschnitte der Nitridschicht 214 angeordnet sind. Gegenüber der Epitaxieschicht 202 ist die Struktur 266 durch die Oxidschicht 204 getrennt. Wie in Fig. 5A ferner zu erkennen ist, wurde hier bereits vor der Erzeugung der Maskierungsschicht 216 sowie der Strukturen 206 und 266 der LDD-Bereich 248 implantiert. Im Gegensatz zu den in Fig. 2D und 3H gezeigten Situationen, wird hier die Maskierungsschicht 216 durch die weitere Struktur 266 unterbrochen, so dass zwischen der Gatestruktur 206 und der Drain-Justage-Struktur 266 ein erster Abschnitt der Maskierungsschicht 216 angeordnet ist, und der verbleibende Drainbereich durch einen zweiten Abschnitt der Maskierungsschicht 216 bedeckt ist. Die Struktur 266 ist über die Schichtfolge 212, 214 (Oxid/Nitrid) von der Maskierungsschicht 216 getrennt.

Die Herstellung 206 und 266 erfolgt auf die anhand der Fig. 2 beschriebenen Art und Weise, also vor dem Aufbringen der Maskierungsschicht 216, welche gemäß einem Beispiel nach der Erzeugung der Strukturen 206 und 266 aufgebracht wird, auf eine Art und Weise, die anhand der Fig. 2A beschrieben wurde. Alternativ können die Strukturen 206 bzw. 266 auf die anhand der Fig. 3 beschriebene Art und Weise erzeugt in der Maskierungsschicht werden.

Der Vorteil dieser Vorgehensweise besteht darin, dass die Strukturen 206 oder 266 mit einem gemeinsamen Photostrukturierungsprozess erzeugt werden, mittels dem der Abstand zwischen der Gatestruktur 206 und der Drain-Justage-Struktur 266 gut eingestellt werden kann. Hierdurch kann auf eine weitere Phototechnik zur Festlegung der drainseitigen Kante der Maskierungsschicht 216 verzichtet werden, wodurch gleichzeitig die mit dieser Festlegung der Kante verbundenen Justagetoleranzen vermieden werden.

Ausgehend von der in Fig. 5A gezeigten Struktur erfolgt nun ein Ätzschritt, um die Maskierungsschicht 216 im Bereich des zukünftigen Drainbereichs zu entfernen. Dieser Ätzschritt erfolgt unter Verwendung einer Phototechnik, mittels der der zwischen der Gatestruktur 206 und der Justage-Struktur 266 liegende Abschnitt der Maskierungsschicht 216 sowie der Sourcebereich der zu erzeugenden Struktur abgedeckt werden. Die Justage der Photoresistkante erfolgt auf dieselbe Art und Weise, die oben in Zusammenhang mit der Erzeugung der Gatestruktur 206 beschrieben wurde. Genauer gesagt, wird eine Kante, die in Fig. 5B bei 268 gestrichelt angedeutet ist, photolithographisch festgelegt, und zwar in einer Solllage, die um eine Justagetoleranz des verwendeten Belichtungsverfahrens von der Kante der Justagestruktur 266 beabstandet ist, die von dem zu entfernenden Abschnitt der Maskierungsschicht beabstandet ist, um so eine Istlage der Kante 268 zu erhalten, die entweder oberhalb der Justagestruktur oder oberhalb des zu entfernenden Abschnitts der Maskierungsstruktur liegt. Hierdurch wird, ähnlich wie bei dem anhand der Fig. 2 und 3 beschriebenen ersten Ausführungsbeispiel, sichergestellt, dass ein Ätzen des zwischen den Strukturen 206 und 266 liegenden Abschnitts der Maskierungsschicht 216 vermieden wird, und aufgrund des selektiven Ätzvorgangs wird nur der über dem zukünftigen Drainbereich liegende Abschnitt der Maskierungsschicht 216 bis zu der Drain-Justage-Struktur 266 entfernt.

Die sich nach dem Ätzschritt ergebende Struktur ist in Fig. 5B gezeigt. Wie zu erkennen ist, ist hier der zukünftige Drainbereich, in Fig. 5B rechts von der weiteren Struktur 266 freigelegt. Nur noch die Oxidschicht 204 und die Nitridschicht 216 sind dort vorhanden.

Anschließend wird, ähnlich wie bei dem anhand der Fig. 2E beschriebenen Schritt, der Sourcebereich, die Gatestruktur 206 sowie zumindest ein Teil der Maskierungsschicht 216 durch die Photoschicht 226 maskiert, so dass eine nachfolgende Implantation von n-Material zur Erzeugung eines Drainbuffers nur in dem freigelegten Drainbereich eingebracht wird. Anders als bei dem anhand der Fig. 2E gezeigten Beispiel, wird bei dem Ausführungsbeispiel gemäß der Fig. 5C die Kante des Implantationsgebiets nicht mehr durch die Photoresistkante 228 festgelegt, sondern durch die Struktur 266. Wie schon oben erwähnt wurde, werden hierdurch die bei der Strukturierung der Photoresistschicht 226 inhärenten Justagetoleranzen und somit die Unsicherheit bei der Anordnung des Drainbereichs vermieden. Es ist ausreichend, wenn bei dem in Fig. 5C gezeigten Ausführungsbeispiel der Sourcebereich sicher bedeckt ist, und die Kante 228 an einer beliebigen Stelle auf den Strukturen 206 und 266 oder auf der Maskierungsschicht 216 angeordnet ist, welche jeweils als Maskierung gegen eine Implantation von n-Material in die darunterliegenden Bereiche wirken. Die Implantation ist in Fig. 5C durch die Pfeile angedeutet.

In Fig. 5D ist die Situation dargestellt, die sich einstellt nachdem das implantierte Material ausgetrieben wurde, um den Drainbuffer 232 zu erzeugen. Dieses Austreiben erfolgt, wie beispielsweise oben schon beschrieben, durch einen Temperaturschritt, durch den eine Diffusion der eingebrachten Drainbufferimplantation unter die Hartmaske erfolgt, wie es in Fig. 5D gezeigt ist.

Anders als bei dem anhand der Fig. 2 und 3 beschriebenen Ausführungsbeispiel wurde bei dem anhand der Fig. 5 beschriebenen Ausführungsbeispiel von einer Situation ausgegangen, bei der vor der Strukturierung des Drainbereichs bereits eine Diffusion des p-Bereichs unter die Gatestruktur 206 durchgeführt wurde. Alternativ kann dies, wie bei den anhand der Fig. 2 und 3 beschriebenen Ausführungsbeispiel, auch zusammen mit der Diffusion des Drainbuffers erfolgen.

Die in Fig. 5D dargestellte Struktur entspricht im wesentlichen der in Fig. 2F bzw. in Fig. 3J dargestellten Struktur, mit Ausnahme der Tatsache, dass in Fig. 5 noch die Struktur 266 vorhanden ist. Diese Struktur 266 kann bei einem Ausführungsbeispiel entfernt werden, bei einem anderen Ausführungsbeispiel kann diese als Potentialplatte über dem Übergang von LDD-Bereich zu Drainbereich verbleiben. Die Entfernung der Struktur 266 erfolgt durch übliche Ätztechniken unter Verwendung einer Phototechnik, um die verbleibenden Bereich zu schützen.

Anschließend wird der LDMOS-Transistor zu Ende prozessiert, entsprechend den Verfahrensschritten die anhand der Fig. 2G bis 2K bzw. 3K bis 3N beschrieben wurden.

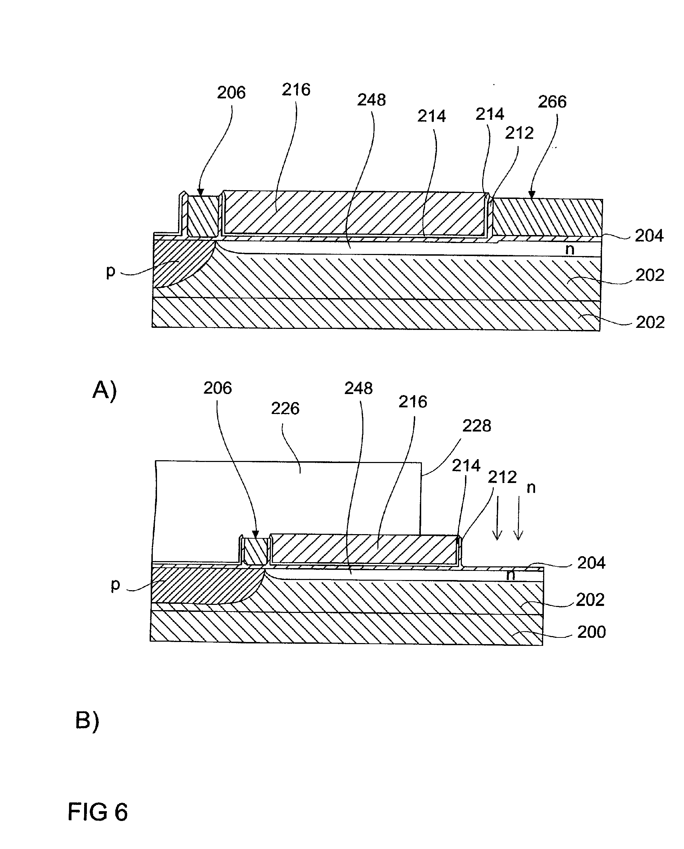

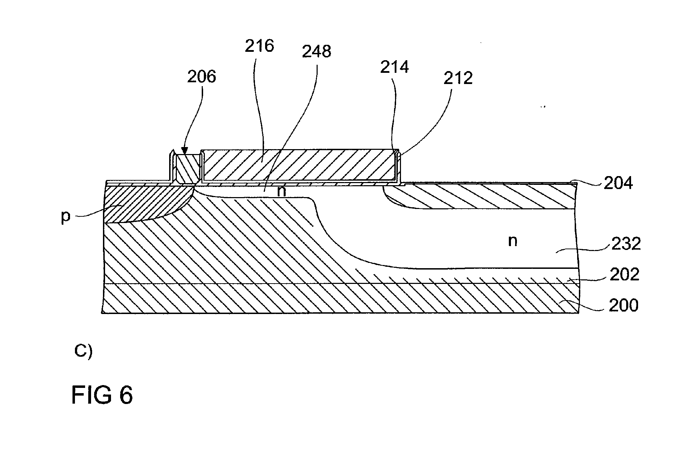

Anhand der Fig. 6 wird nachfolgend ein weiteres Ausführungsbeispiel für die Verwendung einer Drain-Justage-Struktur beschrieben. In Fig. 6A ist dieses weitere Ausführungsbeispiel gezeigt, welches sich von dem anhand der Fig. 5A beschriebenen dadurch unterscheidet, dass die Drain-Justage-Struktur 266 derart ausgebildet ist, dass diese den gesamten zukünftigen Drainbereich bedeckt. Vorzugsweise ist diese Schicht durch ein Polysilizium gebildet. Zwischen der Struktur 266 und der Gatestruktur 206 ist die Maskierungsschicht 216 angeordnet, und dieselbe ist über eine Oxidschicht 212 sowie über eine Nitridschicht 214 von der weiteren Struktur 266 getrennt. Die weitere Struktur 266 ist durch die Oxidschicht 204 von darunterliegenden Schichten getrennt.

Zur Freilegung des Drainbereichs erfolgt nun ein Ätzen des Materials der weiteren Struktur 266, z. B. des Polysiliziums, wobei die Gatestruktur 206, die im Regelfall aus dem gleichen Material hergestellt ist wie die Struktur 266, durch eine Phototechnik zu schützen ist.

In Fig. 6B ist die Situation dargestellt, in der die bereits aus der Fig. 2E bekannte Photoschicht 226 auf dem Sourcebereich, auf dem Gate 206 sowie auf einem Abschnitt der Maskierungsschicht 216 angeordnet ist. Wie auch bei dem anhand der Fig. 5 beschriebenen Ausführungsbeispiel ist es hier nicht erforderlich, den Drainbereich über die Kante 228 der Resistschicht 226 festzulegen, da aufgrund des selektiven Ätzens des Materials der Struktur 266 kein Ätzen der Maskierungsschicht 216 erfolgt, so dass die Kante 228 einfach auf der Maskierungsschicht 216 angeordnet wird, wie dies in Fig. 6 gezeigt ist.

Anschließend erfolgt, wie ebenfalls in Fig. 6 gezeigt ist, eine Implantation von n-Materialen in den nunmehr freigelegten Drainbereich.

Anschließend wird der Photolack 226 entfernt und der Drainbuffer wird ausdiffundiert, so dass sich die in Fig. 6C gezeigte Struktur einstellt, die ähnlich zu der Struktur ist, wie sie in Fig. 2F bzw. 3J gezeigt ist.

Anschließend wird der LDMOS-Transistor fertiggestellt, entsprechend den Schritten, wie sie oben beschrieben wurden.

Sofern bei den anhand der Fig. 5 und 6 beschriebenen Ausführungsbeispiel erwünscht ist, dass der zu erzeugende Drainbereich direkt an die Drainbufferkante angrenzen soll, kann bei diesen Ausführungsbeispielen die nachfolgende Implantation des Sourcebereichs und Drainbereichs ohne weitere Maske erfolgen, wodurch die Drainimplantation ebenso wie die Einbringung des Drainbuffermaterials selbstjustiert erfolgt. Ist ein Abstand der Implantationen von der Drainbufferkante erwünscht, so muss auf die anhand der Fig. 2G beschriebene Phototechnik zurückgegriffen werden.

Ferner kann bei den oben anhand der Fig. 5 und 6 beschriebenen Ausführungsbeispielen das Verfahren ebenfalls zur selbstjustierten Definition eines Drainkontakts verwendet werden, also des Abstands eines zu erzeugenden Metallkontakts zum Anschluss des Drainbereichs. In diesem Fall wird im Drainbereich die Oxidschicht 204 und die Nitridschicht 214 bzw. nur die Oxidschicht 204 (Ausführungsbeispiel gemäß Fig. 6) entfernt, und eine entsprechende Kontaktierung des Drainbereichs wird herbeigeführt. Gleichzeitig kann die Oxidschicht 204 und/oder Nitridschicht 214 im Sourcebereich entfernt werden, und ein entsprechender Kontakt für den Sourceanschluss hergestellt werden. In diesem Fall liegt der Drainkontakt in definierter Entfernung von dem Gate, und der Sourcekontakt reicht bis an das Gate heran.

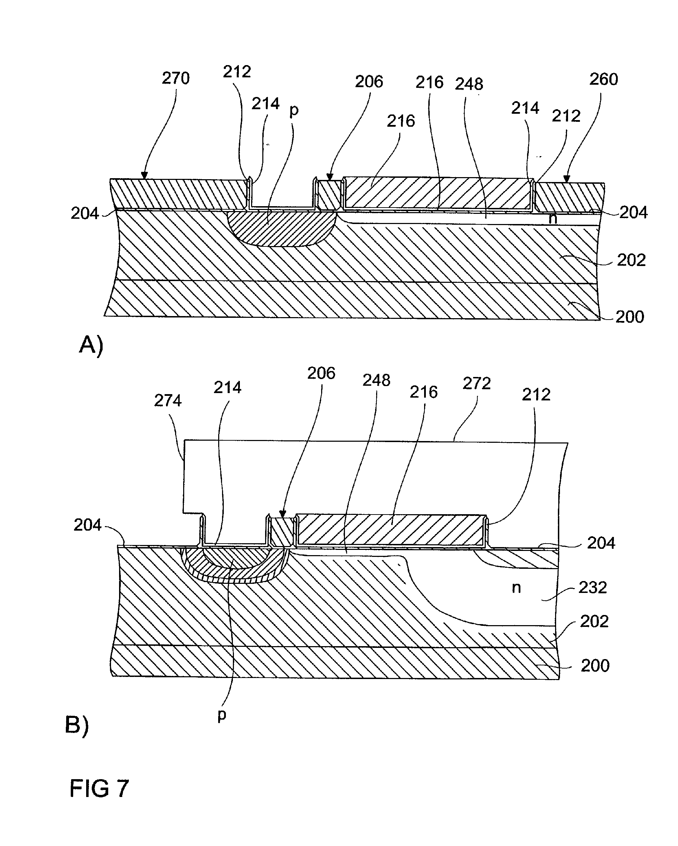

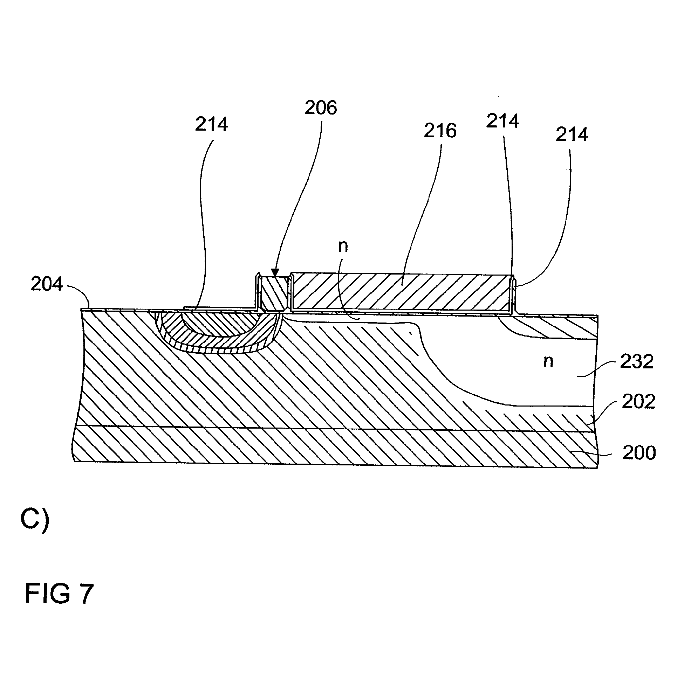

Bei einem anderen Ausführungsbeispiel, welches nachfolgend anhand der Fig. 7 kurz beschrieben wird, ist es wünschenswert, auch einen Abstand zwischen einem Sourcekontakt und dem Gate zu haben, und ein solcher sourceseitiger Widerstand wird bei Leistungs-LDMOS-Transistoren im Hochfrequenzbereich verwendet. Analog zu den oben beschriebenen Verfahren kann dieser ebenfalls selbstjustiert hergestellt werden, wie dies nachfolgend anhand der Fig. 7A-C beschrieben wird.

Beispielhaft ist in Fig. 7A eine Struktur gezeigt, die ähnlich zu der in Fig. 6A ist, wobei jedoch die Darstellung ferner den sourceseitigen Bereich (in der Figur links von der Gatestruktur 206) einschließt. Zusätzlich zu der in Fig. 6A gezeigten Anordnung, ist hier eine weitere, Source-Justage-Struktur 270 gezeigt, die, beabstandet von dem Gate 206 oberhalb eines noch zu erzeugenden Sourcebereichs angeordnet ist. Die Struktur 270 besteht ähnlich wie die übrigen Strukturen beispielsweise aus Polysilizium und ist gegenüber dem darunterliegenden Substratbereich durch die Oxidschicht 204 isoliert. Von einer, in Fig. 7A bereits durch das erfindungsgemäße Verfahren entfernten Maskierungsschicht, war diese durch die Oxidschicht 214 und eine weitere Oxidschicht 212 isoliert, ähnlich wie die Struktur 266 von dem Abschnitt 216 der Maskierungsschicht. Durch den entstandenen Graben erfolgt die p-Implantation des Kanals. Die Struktur 270 wird gemeinsam mit den übrigen Strukturen 206 und 266 oder nur mit der Struktur 206, sofern nur ein entsprechender Abstand zwischen Source und Gate erwünscht ist, erzeugt, was, wie oben erwähnt wurde, zusammen mit der Gate-Herstellung mit hoher Genauigkeit erfolgen kann. Alternativ zu der Strukturform 270 kann auch eine Strukturform ähnlich zu der gewählt werden, die anhand der Fig. 5A in Zusammenhang mit der Drain-Justage-Struktur 266 beschrieben wurde.

In einem nachfolgenden Ätzschritt, wird die Struktur 270 entfernt, wobei die übrigen Bereiche des Substrats mit einer Photoresistschicht 272 bedeckt sind, um ein unerwünschtes Ätzen anderer Teile zu vermeiden. Bei dem in Fig. 7B gezeigten Beispiel ist angenommen, dass hier bereits die Entfernung der Drain-Justage-Struktur 266 erfolgt ist, ebenso wie das Eindiffundieren der Drainbufferimplantation. Die Kante 274 der Photoresistschicht 272 wird derart festgelegt, dass diese auf der Polysiliziumstruktur 270 angeordnet ist. Hierdurch ist sichergestellt, dass der Bereich, in dem bereits die Maskierungsschicht entfernt wurde, nämlich der Bereich zwischen der Struktur 270 und dem Gate 206 ebenfalls von der Photoresistschicht 272 geschützt ist, so dass im nachfolgenden Ätzschritt lediglich die Polysiliziumstruktur 270 sowie die an deren Kante angeordnete Oxidschicht 212 und die an der Kante angeordnete Nitridschicht 214 entfernt werden, so dass in diesem Bereich nur die Oxidschicht 204 zurückbleibt, wohingegen benachbart zum Gate die Nitridschicht 214 und die Oxidschicht 204 zurückbleiben.

Die sich ergebende Struktur ist in Fig. 7C gezeigt. In einem späteren Schritt, nach der Implantation und Ausheilung der Source- und Draingebiete wird bei der Erzeugung der Anschlusskontakte zunächst selektiv die Oxidschicht 204 in dem Bereich geätzt, in denen dieselbe nicht durch die Nitridschicht 214 geschützt ist. In den dadurch freigelegten Bereichen des Sourceabschnitts bzw. des Drainabschnitts erfolgt dann die metallische Kontaktierung.

Obwohl die obige Beschreibung der bevorzugten Ausführungsbeispiele der vorliegenden Erfindung anhand von Herstellungsprozessen für LDMOS-Transistoren mit LDD-Bereich erfolgte, wird darauf hingewiesen, dass das erfindungsgemäße Verfahren allgemein in Situationen einsetzbar ist, in denen Bereiche eines Substrats benachbart zu einer Struktur unter Einhaltung minimaler Strukturgrößen bearbeitet werden müssen, wobei andere Gebiete benachbart zu der Struktur geschützt sein müssen. Neben der Herstellung von LDMOS-Transistoren findet die vorliegende Erfindung auch Anwendung auf MOS-Transistoren mit LDD-Bereich.

Obwohl oben in den bevorzugten Ausführungsbeispielen die Verwendung von p-Substraten und n-Implantationen beschrieben wurde, ist es selbstverständlich auch möglich die vorliegende Erfindung auf Herstellungsverfahren unter Verwendung von n-Substraten und p-Implantationen anzuwenden.

### Bezugszeichenliste

- 100: Substrat
- 102: Sourcebereich
- 104: LDD-Bereich
- 106: Oberfläche
- 108: Gatestruktur
- 110: Photoresistschicht
- 112: Kante der Photoresistschicht 110
- 114: Implantation
- 116: Ist-Kante der Photoresistschicht 110
- 118: maskierter Abschnitt des Sourcebereichs 102
- 120: freigelegter Abschnitt des LDD-Bereichs 104
- 200: Substrat
- 202: Epitaxieschicht
- 204: erste Oxidschicht
- 206: Gatestruktur
- 208: Gatepolysiliziumabschnitt
- 210: Gateoxidabschnitt
- 212: weitere Oxidschicht
- 214: Ätzstoppschicht
- 216: Hartmaske
- 218: Oberkante der Hartmaske
- 220: Oberkante der Gatestruktur 206
- 222: Photoresistschicht
- 224: Kante der Photoresistschicht 222
- 226: Photoresistschicht
- 228: Kante der Photoresistschicht 226
- 230: Kanalbereich
- 232: Drainpuffer
- 234: Kante der Hartmaske 216
- 236: Photoresistschicht
- 238: erste Kante der Photoresistschicht 236
- 240: zweite Kante der Photoresistschicht 236
- 242: Photoresistschicht
- 244: Kante der Photoresistschicht 242
- 246: n⁺-Source
- 248: n-LDD-Bereich
- 250: n⁺-Drain
- 252-256: Aluminiumanschlussflächen
- 258: Graben
- 260: Nitridschicht
- 262: Gatematerial
- 264: Spacer
- 266: Drain-Justage-Struktur
- 268: Photoresistkante
- 270: Source-Justage-Struktur
- 272: Photoresistschicht
- 274: Kante der Photoresistschicht 272

## Patentansprüche

1. Verfahren zum photolithographischen Festlegen eines freigelegten Substratbereichs, der direkt an eine auf dem Substrat (200, 202) angeordnete Struktur (206; 266; 270) angrenzt, mit folgenden Schritten:
(a) Aufbringen einer Maskierungsschicht (216), die bis an die Struktur (206; 266; 270) heranreicht, auf dem Substrat (200, 202);
(b) Aufbringen einer Photoresistschicht (222);
(c) photolithographisches Festlegen einer Kante (224) der Photoresistschicht (222) in einer Solllage, die um mindestens eine Justagetoleranz eines Belichtungsverfahrens von einer Kante der Struktur (206; 266; 270) beabstandet ist, die an einen nicht zu entfernenden Abschnitt der Maskierungsschicht (216) angrenzt, um eine Istlage der Kante (224) der Photoresistschicht (222) zu erhalten, die entweder oberhalb der Struktur (206; 266; 270) oder oberhalb des zu entfernenden Abschnitts der Maskierungsschicht (216) liegt; und
(d) Ätzen der Maskierungsschicht (216) unter Verwendung der im Schritt (c) strukturierten Photoresistschicht (222), um die Maskierungsschicht (216) bis zu der Struktur (206; 266; 270) zu entfernen.

2. Verfahren nach Anspruch 1, mit folgendem Schritt vor dem Schritt (a):
Bereitstellen des Substrats (200, 202), wobei die Struktur (206; 266; 270) auf einer Oberfläche des Substrats (200, 202) gebildet ist.

3. Verfahren nach Anspruch 1, bei dem der Schritt (a) folgende Teilschritte umfasst:
(a.1) Aufbringen der Maskierungsschicht (216) auf einer Oberfläche des Substrats (200, 202);
(a.2) Bilden einer Ausnehmung (258) in der Maskierungsschicht (216), die von einer dem Substrat (200, 202) abgewandten Oberfläche der Maskierungsschicht (216) bis zu der Oberfläche des Substrats (200, 202) reicht; und
(a.3) Einbringen eines ausgewählten Materials (208, 210) in die Ausnehmung (258), um die Struktur (206; 266; 270) zu bilden.

4. Verfahren nach Anspruch 3, bei dem die Ausnehmung (258) die kleinste, lithographisch erreichbare Abmessung hat, und bei der der Schritt (a.3) folgende Schritte umfasst:
Bilden einer Beabstandungsschicht (264) an den Wänden der Ausnehmung (258); und
Einbringen des Strukturmaterials (262), um eine Struktur (206; 266; 270) mit einer Abmessung zu bilden, die kleiner ist als die kleinste lithographisch erreichbare Abmessung.

5. Verfahren nach einem der Ansprüche 1 bis 4, bei dem die Maskierungsschicht (216) aus einem Material gebildet ist, das bezüglich dem Substratmaterial und bezüglich dem Strukturmaterial selektiv ätzbar ist.

6. Verfahren nach einem der Ansprüche 1 bis 5, bei dem zwischen dem Substrat (200, 202) und der Maskierungsschicht (216) und/oder zwischen der Struktur (206; 266; 270) und der Maskierungsschicht (216) eine Ätzstoppschicht (214, 260) angeordnet ist.

7. Verfahren nach einem der Ansprüche 1 bis 6, bei dem der Schritt (d) ein isotropes und/oder anisotropes Ätzen umfasst.

8. Verfahren nach einem der Ansprüche 1 bis 7, bei dem die auf dem Substrat (200, 202) angeordnete Struktur ein Gate (206) eines MOS-Transistors ist, und bei dem der freigelegte Substratbereich einen Sourcebereich des MOS-Transistors in dem Substrat (200, 202) definiert.

9. Verfahren nach einem der Ansprüche 1 bis 7, bei dem die auf dem Substrat (200, 202) angeordnete Struktur eine Drain-Justage-Struktur (266) ist, die an einem Übergang eines LDD-Bereichs oder Resurf-Bereichs (248) zu einem Drainbereich (250) eines LDMOS-Transistors angeordnet ist, wobei der freigelegte Substratbereich der Drainbereich (250) des MOS-Transistors ist.

10. Verfahren nach Anspruch 8, das ferner folgende Schritte umfasst:
(e) photolithographisches Freilegen eines Substratbereichs, der von der Maskierungsschicht (216) bedeckt und von dem Gate (206) beabstandet ist, um einen Drainbereich des MOS-Transistors in dem Substrat (200, 202) zu definieren;
(f) Erzeugen der Source (246) des MOS-Transistors und der Drain (250) des MOS-Transistors in dem Sourcebereich bzw. in dem Drainbereich in dem Substrat (200, 202);
(g) photolithographisches Festlegen einer weiteren Kante (244) der Photoresistschicht (242) in einer Solllage, die um eine Justagetoleranz eines Belichtungsverfahrens von einer weiteren Kante des Gates (206) beabstandet ist, die an einen Abschnitt der Maskierungsschicht (216) zwischen dem Gate (206) und der Source (246) angrenzt, um eine Istlage der Kante (244) der Photoresistschicht (242) zu erhalten, die entweder oberhalb des Gates (206) oder oberhalb des Abschnitts der Maskierungsschicht (216) zwischen dem Gate (206) und der Drain (250) liegt; und
(h) Ätzen der Maskierungsschicht (216) unter Verwendung der im Schritt (g) strukturierten Photoresistschicht (242), um die Maskierungsschicht (216) bis zu dem Gate (206) zu entfernen; und
(i) Erzeugen einer leicht dotierten Drain (248) in dem Substrat (200, 202), zwischen dem Gate (206) und der Drain (250).

11. Verfahren nach Anspruch 10, mit folgenden Schritten vor dem Schritt (e)
Entfernen der Photoresistschicht (222);
Einbringen einer Implantation zur Erzeugung eines lateral diffundierten Kanals in den Sourcebereich; und
Aufbringen einer weiteren Photoresistschicht (226);
wobei das Verfahren folgende Schritte zwischen dem Schritt (e) und dem Schritt (f) umfasst:
Einbringen einer Implantation zur Erzeugung eines Drainbereichs, dessen Dotierungskonzentration zwischen der Drainkontaktimplantation und der LDD-Implantation liegt (Drainbuffer) ;
Eindiffundieren der in den Sourcebereich eingebrachten Implantation unter das Gate (206) und Eindiffundieren der in den Drainbereich angebrachten Implantation unter die angrenzende Maskierungsschicht (216); und
Abdecken der Maskierungsschicht (216) zwischen dem Gate (206) und der Drain (250) mittels einer Photoresistschicht (236);
wobei nach dem Schritt (f) die Photoresistschicht (236) entfernt wird und eine neue Photoresistschicht (242) vollständig auf die Oberfläche aufgebracht wird.

12. Verfahren nach Anspruch 8, bei dem auf dem Substrat (200; 202) eine weitere Struktur (266) angeordnet ist, die eine Drain-Justage-Struktur ist, die an einem Übergang des LDD-Bereichs (248) zu dem Drainbereich (250) des LDD-MOS-Transistors angeordnet ist, wobei ein Abschnitt der Maskierungsschicht (216) zwischen dem Gate (206) und der Drain-Justage-Struktur (266) angeordnet ist, mit folgenden Schritten:
(e) photolithographisches Festlegen einer Kante (268) einer Photoresistschicht, die das Gate und die Maskierungsschicht bedeckt, in der Solllage, die um mindestens eine Justagetoleranz eines Belichtungsverfahrens von einer Kante der weiteren Struktur (266) beabstandet ist, die an einen nicht zu entfernenden Abschnitt der Maskierungsschicht (216) angrenzt, um eine Istlage der Kante (268) der Photoresistschicht zu erhalten, die entweder oberhalb der weiteren Struktur (266) oder oberhalb des zu entfernenden Abschnitts der Maskierungsschicht (216) liegt;
(f) Ätzen der Maskierungsschicht (216) unter Verwendung der im Schritt (e) strukturierten Photoresistschicht, um die Maskierungsschicht (216) zu der weiteren Struktur (266) zu entfernen, um den Drainbereich freizulegen; und
(g) Erzeugen der Source (246) und der Drain (250) des MOS-Transistors in dem Substrat (200, 202).

13. Verfahren nach Anspruch 13, bei dem der LDD-Bereich (248) des MOS-Transistors vor dem Erzeugen der Gatestruktur (206) und der Drain-Justage-Struktur (266) erzeugt wird, oder bei dem der LDD-Bereich (248) des MOS-Transistors zusammen mit der Source (246) und der Drain (250) erzeugt wird.

14. Verfahren nach Anspruch 12 oder 13, mit folgenden Schritten nach dem Schritt (e):
Entfernen der Photoresistschicht; und
Einbringen einer Implantation zur Erzeugung eines lateral diffundierten Kanals in den Sourcebereich;
wobei das Verfahren folgende Schritte zwischen dem Schritt (f) und dem Schritt (g) umfasst:
Einbringen einer Implantation zur Erzeugung eines Drainbuffers (232) in dem Drainbereich; und
Eindiffundieren der in den Sourcebereich eingebrachten Implantation unter das Gate (206) und Eindiffundieren der in den Drainbereich eingebrachten Implantation unter die angrenzende Maskierungsschicht (216).

15. Verfahren nach einem der Ansprüche 12 bis 14, bei dem die weitere Struktur (266) entfernt wird.

16. Verfahren nach Anspruch 8, bei dem auf dem Substrat eine weitere Struktur (266) angeordnet ist, die einen Drainbereich (250) des MOS-Transistors bedeckt, wobei ein Abschnitt der Maskierungsschicht (216) zwischen dem Gate (206) und der weiteren Struktur (266) angeordnet ist, mit folgenden Schritten:
(e) Entfernen der weiteren Struktur (266), um einen Drainbereich freizulegen; und
(f) Erzeugen der Source (246) und der Drain (250) des MOS-Transistors in dem Substrat (200, 202).

17. Verfahren nach Anspruch 15, bei dem der LDD-Bereich (248) des MOS-Transistors vor dem Erzeugen der Gatestruktur (206) und der Drain-Justage-Struktur (266) implantiert wird, oder bei dem der LDD-Bereich (248) des MOS-Transistors zusammen mit der Source (246) und der Drain implantiert wird.

18. Verfahren nach Anspruch 16 oder 17 mit folgendem Schritt nach dem Schritt (e):
Einbringen einer Implantation zur Erzeugung eines lateral diffundierten Kanals in den Sourcebereich;
wobei das Verfahren folgende Schritte zwischen dem Schritt (e) und dem Schritt (f) umfasst:
Einbringen einer Implantation zur Erzeugung eines Drainbuffers in dem Drainbereich; und
Eindiffundieren der in den Sourcebereich eingebrachten Implantation unter das Gate (206) und Eindiffundieren der in den Drainbereich eingebrachten Implantation unter die angrenzende Maskierungsschicht (216).

19. Verfahren nach einem der Ansprüche 12 bis 18, bei dem die Struktur (206) und die weitere Struktur (266) gemeinsam erzeugt werden.

20. Verfahren nach einem der Ansprüche 9 bis 19, bei dem die weitere Struktur (266) eine Position eines Drainkontakts (256) auf dem Substrat (200, 202) festlegt.

21. Verfahren nach einem der Ansprüche 8 bis 20, bei dem auf dem Substrat (200, 202) eine dritte Struktur (270) angeordnet ist, die beabstandet zu dem Gate (206) angeordnet ist und einen Sourcebereich des MOS-Transistors zumindest teilweise bedeckt, um eine Position eines Sourcekontakts (252), der beabstandet von dem Gate (206) angeordnet wird, festzulegen.

22. Verfahren nach einem der Ansprüche 8 bis 21, mit folgenden Schritten:
Ausheilen der erzeugten Halbleiterstruktur; und
Aufbringen von metallischen Anschlussstellen (252, 254, 256) auf dem Gate (206), der Source (246) und der Drain (250), um den Gatekontakt, den Sourcekontakt und den Drainkontakt zu bilden.
